# EUROPEAN PATENT SPECIFICATION

(11) **EP 2 985 920 B1**
(45) Date of publication and mention of the grant of the patent: **24.04.2019**
(21) Application number: 14782319.9
(22) Date of filing: 09.04.2014
(51) Int. Cl.: H04B 3/46, G01R 31/02, H02J 13/00

(54) **REAL TIME, AUTOMATIC DIAGNOSTIC SYSTEM AND METHOD FOR ELECTRIC NETWORKS**
AUTOMATISCHES ECHTZEITDIAGNOSESYSTEM UND -VERFAHREN FÜR STROMNETZWERKE
SYSTÈME ET PROCÉDÉ POUR DIAGNOSTICS AUTOMATIQUES ET EN TEMPS RÉEL SUR DES RÉSEAUX ÉLECTRIQUES

(30) Priority: 09.04.2013 BR 102013008594
(43) Date of publication of application: 17.02.2016
(73) Proprietor: Companhia Hidro Elétrica do São Francisco, 54745-790 Recife PE (BR)
(72) Inventor: MELO, Maria do Socorro Cavalcanti de, CEP-52011-200 Recife - PE (BR); SAMPAIO, Marcus Costa, CEP-60170-210 Fortaleza - CE (BR); DUARTE, Alexandre Nobrega, CEP-58000-000 João Pessoa - PB (BR); NETO, Eloi Rocha, CEP-58039-190 João Pessoa - PB (BR); SAUVÉ, Jacques Philippe, CEP-58310-000 Cabedelo - PB (BR); FIGUEIREDO, Jorge César Abrantes de, CEP-58103-253 Campina Grande - PB (BR); NICOLLETTI, Pedro Sergio, CEP-58429-100 Universitário Campina Grande - PB (BR); PIRES, Stéfani Silva, CEP-44900-970 Irecê - BA (BR); FILHO, Walfredo da Costa Cirne, Palo Alto, CA 94303 (US); ARAÚJO, António Sérgio de, CEP-52020-220 Recife - PE (BR)
(74) Representative: Capasso, Olga
(86) International application number: PCT/BR2014/000121
(87) International publication number: WO 2014/165957

(56) References cited:
- WO-A1-2012/008093
- WO-A2-2011/151480
- CN-A- 102 426 667
- CN-A- 102 545 381
- US-A1- 2011 282 508
- US-A1- 2012 022 707
- H-J HEUNG-JAE LEE ET AL: "A Fuzzy Expert System for the Integrated Fault Diagnosis", IEEE TRANSACTIONS ON POWER DELIVERY, IEEE SERVICE CENTER, NEW YORK, NY, US, vol. 15, no. 2, 1 April 2000 (2000-04-01), XP011049830, ISSN: 0885-8977

## Description

### Field of the Invention

The present invention is in the field of Electrical Engineering. More specifically, the present invention provides a system and method for performing real-time and automatic diagnostics of failures in equipments located in electrical grids such as, for example, transmission and generation grids of electric power. The system and method of the invention comprises the use of "generic rules" that harmonize the huge amounts of diagnostic points with the capabilities of systems, so as to provide event correlation, particularly applied to electrical grids with constant topology modifications.

### Background of the Invention

The supervision and control centers of modern distribution and transmission of electric power have the complex task of managing large and geographically comprehensive grids. Such centers acquire a large amount of data over the electrical grid, thereby enabling the diagnostic and localization of abnormal conditions in the system. There are in modern control centers systems responsible for monitoring the load in the system, by analysis of contingencies, the short-circuit analysis, among other functions. However, the expert knowledge of human operators is still necessary to supervise the system and make critical decisions, especially in emergency situations. In such situations, great amounts of events are usually generated (indicating potentially abnormal situations), a ripple effect often caused by a single failure. There are records of critical situations in control centers wherein the operators received more than 1,500 events in a single second.

The large volume of events in critical situations is a problem for system operation as it increases the time of diagnostic and reaction from operator, who have to "digest" all events outbreak to identify the real problems in the system. Thus, at critical moments when, because of the seriousness of the situation and the number of customers affected, the diagnostic should be done as quickly as possible so that corrective actions can be performed, the time taken by operators to find out what is really going on in the electrical grid is much higher. In addition, humans are liable to make mistakes in stressful situations, and an incorrect diagnostic may worsen the situation even more once a wrong corrective action can damage equipment or propagate the effects of a localized failure to other parts of the system.

Companies and research groups have researched and developed techniques and applications for failure diagnostic in different types of networks such as computer networks, electrical grids and telecommunications networks. Apparently they have not considered the possibility of applying a technique or application developed for one type of network in other types. More precisely, most diagnostic techniques and event correlation used in computer networks and telecommunications networks have not been applied in failure diagnostic in electrical grids, although there is no theoretical impediment to that. Maybe because of this fact, a reasonable number of commercial applications for failure diagnostic in computer networks and telecommunications networks exists, and a very small number of applications for electrical grids. Furthermore, another problem is an excessive number of rules to model a single problem.

The reasoning involved in failure diagnostic in power systems is eminently symbolic, which enables the automation through systems. This fact raised the possibility of using applications based on knowledge for the automatic processing of events, allowing the association of a series of correlated events with a single root cause.

A crucial factor for the success of an event correlation system is the choice of an event correlation technique that is suitable to the environment in which the system will conduct its diagnostic.

Due to the existence of a partial knowledge base in the form of correlation rules, created for an earlier project not completed, it was chosen the easiest technique to be implemented according to the situation: the rule-based reasoning. Another advantage of this choice is that the client already has a previous experience in the production of rules, which would facilitate the completion of the knowledge base. However, that choice resulted in two major problems:
- The large number of rules needed to model the network problems;
- Constant maintenance due to changes in the grid topology.

For example, to only model the failure of the tiny part of the transmission lines currently supervised, 1,334 rules are required. Assuming that each of the regional centers has approximately the same number of equipment and the rules of transmission lines represents half of all rules for each center, it can be estimated that more than 10,000 rules would be necessary to model all the problems of all the transmission network equipment.

In a specific case, for example, only in October 2002, there were eight changes in the topology of a certain grid of high-voltage lines. Using the reasoning based on conventional rules, it would be necessary to rewrite or update the rule base whenever there is a modification in the grid topology. With a base of 10,000 rules, this task becomes quite difficult, making impossible, in fact, the effective usage of such technique.

Some publications are partially known related to the subject of the present invention, but without, however, anticipating or even suggesting them. Examples include some articles like:
- ABOELELA E.; DOULEGERIS C., Fuzzy Temporal Reasoning Model for Event Correlation in Network Management, 24th Conference on Local Computer Networks, LCN'99, Lowell, Massachusetts, USA, pp.150-159, October 1999.
- BIELER, K.; GLAVITSCH, H. Evaluation of different Al-methods for fault diagnostic in power systems. In:. International Conference on Intelligent System Application to Power Systems, 1994, Nanterre Cedex, France, v. 1, p. 209-216, 1994.
- HIYAMA, T. Current Status of Fuzzy System Applications in Power Systems. Department of Electrical and Computer Engineering. Kumamoto University, Kumamoto, Japan. 1999.
- JOYA, G., Connectionist Solutions for Energy Management Systems. ESQNN'2000 proceedings - European Symposium on Artificial Neural Networks, Bruges, Belgium. April 2000.
- LEE H.; PARK D.;AHN B.; PARK Y.; A Fuzzy Expert System for the Integrated Fault Diagnostic, IEEE TRANSACTIONS ON POWER DELIVERY, VOL. 15, NO. 2, April, 2000.
- LO C.; CHEN S.; LIN B. Coding-based schemes for fault identification in communication networks. John Wiley & Sons, Inc. New York, NY, USA, 1998.
- KLIGER, S.; YEMINI, S.; YEMINI, Y.; OHSIE, D.; STOLFO, S. A coding approach to event correlation. In IFIP/IEEE International Symposium on Integrated Network Management, 4, p. 266-277. 1995.
- MAMDANI, E. H. An experiment in linguistic synthesis with a fuzzy logic controller. International Journal of Man-Machine Studies, Vol. 7, No. 1, pp. 1-13, 1975.
- MEIRA, D. A Model for Alarm Correlation in Telecommunications Networks. Tese de Doutorado em Ciência da Computação. Instituto de Ciências Exatas (ICEx) da UFMG. Belo Horizonte, Brazil, 1997.
- OHSIE, D. A., Modeled Abductive Inference for Event Management and Correlation. Ph.D. Thesis. Graduate School of Arts and Sciences. Columbia University, 1998.
- YEMINI, S.; KLIGER, S.; MOZES, E.; YEMINI, Y.; OHSIE, D. High Speed and Robust Event Correlation. IEEE Communications Magazine, p. 82-90, May, 1996.
- YEMINI, Y.; YEMINI, S.; KLIGER, S. Apparatus and Method for Event Correlation and Problem Reporting, United States Patent 5,528,516, 1996.

Patent-wise, some documents describe some systems and/or methods for monitoring and diagnosing in electrical grids. References that circumscribe the invention without, however, anticipating them or even suggesting them, are listed below.

US 5,388,189 discloses a data network where alarms are provided that are filtered to eliminate redundant alarms and also provides diagnostic.

US 7,840,395 discloses an electrical system where real-time failure analyses are provided.

US 2011/066301 discloses a system and method for monitoring and controlling an electrical system.

US 2008/120080 discloses a system for alarm filtering and real-time data interpretation of an electrical system.

US 2012/022707 discloses a electrical grid where the occurred events are monitored and provides data visualization.

US 2011/282508 discloses a security platform that can control electric power distribution and operations in a transmission and distribution grid of electric power in real-time where the data can be analyzed.

WO2011/151480 discloses a method for real-time diagnosis of the sources of partial discharge in high-voltage equipment and installations using parameters associated with the time of the impulse front, tail time and pulse frequency.

The present invention differs from the cited documents, among other technical reasons, to provide a system for performing real-time and automatic diagnostics of failures in equipments located in generation and transmission grids of electric power through rules called "generic rules", where these rules use events correlation, preferably designed for grids with constant topology modifications. The present invention combines the concept based on rules with the concept based on models that facilitates and expedites the construction of the knowledge base, in addition to reducing the need to upgrade due to changes in the electrical grid topology. The present invention provides a small number of rules necessary to model the problems in an electrical grid by allowing the same rule can be reused for various equipments.

### Summary of the Invention

The present invention discloses a method and a system for real-time and automatic diagnostic in electrical fields in accordance with the independent claims.

In particular, the present invention provides a method for real-time and automatic diagnostics in electrical grids, comprising the following steps:
i. checking if the equipment is connected/energized or not connected;
ii. checking if the equipment was connected/energized or not connected;
iii. modeling the connections between equipments of the electrical grid;
iv. creation of topological parameters for inserting generic rules to the equipment type and/or type(s) of equipment(s);
v. generating diagnostics through said generic rules;
vi. updating the state of topology comprising:
   - removing diagnostic(s) with expired symptom(s);
   - recovering diagnostics with network's symptoms; and
   - adding symptoms in the associated equipment;
wherein said generic rules being applied on equipment classes, translating if the transmission line is connected or not to some energized equipment and comprise rule(s) and/or macro(s) and/or attribute(s).

The present invention provides a method for performing real-time and automatic diagnostics and failures in equipments located in transmission and generation grid of electric power through rules called "general rules". The method of the present invention combines rule-based reasoning with reasoning based on models and that facilitates the construction of the knowledge base, in addition to reducing the need to update due to changes in the electrical grid topology. The method of the present invention provides a small number of rules necessary to model the problems in the electrical grid by allowing the same rule can be reused for various equipments.

It is therefore an object of the present invention a method for performing real-time and automatic diagnostics in failures in equipments located in
generation and transmission grid of electric power, said method comprising the steps of:
i. updating the status of all equipment;
ii. initiating data structures;
iii. creating diagnostics; and
iv. updating the status of all equipments according to the network's symptoms.

In another aspect, being therefore a further object of the invention, there is provided a method where generic rules are applied to classes of equipment, said method comprising the steps of:
i. checking if equipment is connected (energized) or not connected
ii. checking if equipment was connected (energized) or not connected;
iii. inserting rule(s) and/or macro(s) and/or attribute(s) to equipment(s) and/or type(s) of equipment(s);
iv. generating diagnostics for each equipment E and for each rule R in equipment and for each attribute A in equipment through condition of existence and activation condition;
v. replacing the variables in the text(s) of diagnostic(es); and
vi. sending diagnostic(es).

The method can further comprise the following steps:
vii. Remove diagnostic(es) with expired symptom(s);
viii. Recover diagnostics with network's symptoms; and
ix. Add symptoms in the associated equipment.
wherein said generic rules are applied on equipment classes, translating if the transmission line is or is not connected to any energized equipment.

Preferably, an equipment can have several associated equipments and, in turn, associated equipment can have several associated equipments.

The method of the present invention preferably uses the Root Cause logic to recover diagnostics according to the symptoms on the network.

The method of the present invention preferably uses the Topological Primitives logic to inform the current topology of the grid in the generation of diagnostics.

The present invention provides a system able to perform real-time and automatic diagnostics of failures in equipments located in transmission and generation grids of electric power using rules called "generic rules".

In one aspect, the present invention provides a system comprising:
i) Means for generating the topology;
ii) Means for interconnecting networks;
iii) Means for maintaining a representation of the topology of electrical grid;
iv) Means for generating diagnostics through generic rules based on the collected information;
v) Means for generating the screens of the diagnostics;
vi) Means for generating reports.

The system of the invention can further comprise:
vii) Means to inform the availability of operating each system module.

Preferably, said means for generating the topology can be a embodiment called "Topogiggio", where it accesses the tables in the electrical grid management system, such as Sage (Sistema Aberto de Supervisão e Controle | *Open System of Supervision and Control)* and generates XML files containing the complete topology of the electrical grid.

Preferably, said means for interconnecting networks can be a Gateway, which accesses electrical grid management system, such as the Sage (*Sistema Aberto de Supervisão e Controle* | *Open System of Supervision and Control)* to retrieve in real time alarms, events, analog magnitudes and/or opening states of all circuit breakers and electrical grid switches.

Preferably, said means for updating the state of the topology can be an embodiment called "Model", which accesses the Gateway. It has a noise filter that evaluates whether the information retrieved from the system, being correct or not, if not, alarms or events are removed or inserted, so that the end the state of the topology is consistent.

### Brief Description of the Drawings

Figure 1 shows a root cause analysis system with Smart Alarm information and topology being Relations of Flow Propagation (RPF | *Relações de Propagação de Fluxo*), Flow-Based Model (MBF | *Modelo Baseado em Fluxo*), Filter of Diagnostics (FD | *Filtro de Diagnostics*), Equipment Filter (FE | *Filtro de Equipment*), Intermediate Model (MI | *Modelo Intermediário*), Propagation Rules (RP | *Rules de Propagação*), Cronology (C | *Cronologia*) and Final Model (MF | *Modelo Final*).
Figure 2 shows an example of topology.
Figure 3 shows a model based on energy flow.
Figure 4 shows an intermediate model.
Figure 5 shows the flow relations of the model.
Figure 6 shows a final model.
Figure 7 shows a graph representing the energy flow between the elements in the first scenario.
Figure 8 shows a graph representing the energy flow between the elements in the second scenario.
Figure 9 shows a graph if the filter step needs to separate the alarms by diagnostic and by element type.
Figure 10 shows a graph if the rule 1 confirms the relation R1 of the graph; rule 2 modifies the relation R2 of the graph, changing the direction of the relation, thus indicating that the alarm 7 occurred first; rule 3 confirms the relation R3 of the graph, thus maintaining the connection.
Figure 11 shows a graph representing the energy flow between the elements in the third scenario.
Figure 12 shows the graph IF the alarm 2 occurs first.

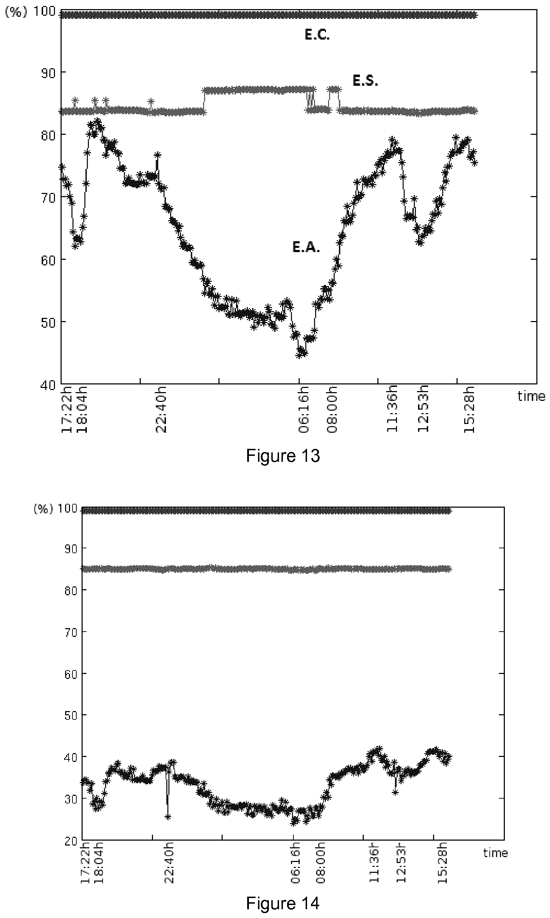

Figure 13 shows the stability of the CRD1B1 Bar over time being C.S. Critical Stability, S.S. Security Stability and C.S. Current Stability.
Figure 14 shows the stability of the ACD2(5463) Bar over time.

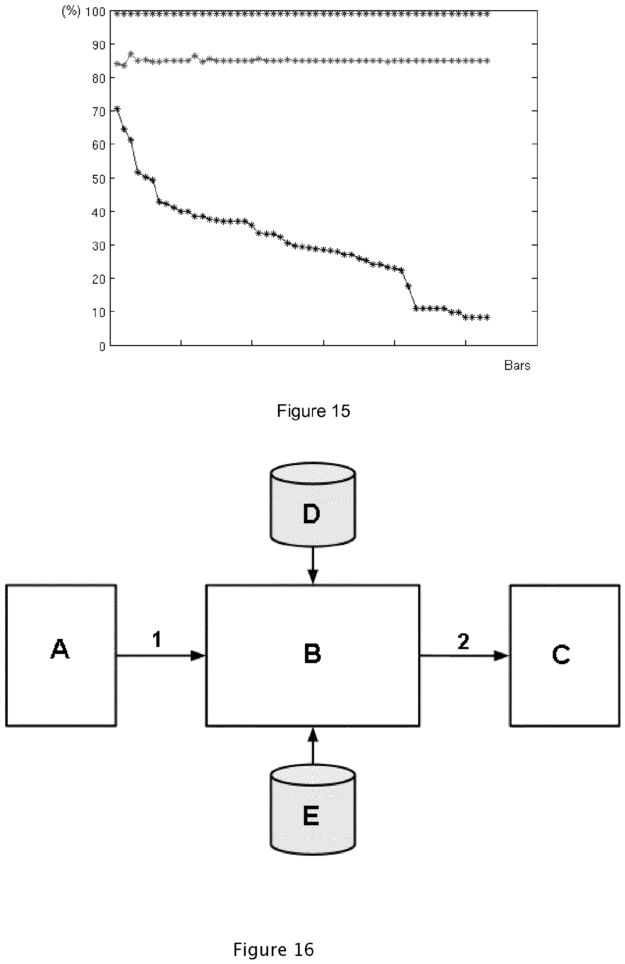

Figure 15 shows the illustration of the stability distribution for the bars in a case.
Figure 16 shows the illustration of the invention system architecture comprising the following elements: (A) Electrical Grid, (B) Events Processor and Alarms Sender, (C) Alarms Viewer, (D) Bank of Rules, (E) Electrical Grid Topology, (1) Events (Symptoms) and (2) Alarms.
Figure 17 shows the illustration of an electrical grid topology containing four equipments and three connectivity nodes.
Figure 18 shows a type of terminal of transmission line.
Figure 19 shows a type of terminal of transmission line with a failure occurred in the circuit breaker.
Figure 20 shows an installation of 230 kV with a failure occurred inf the circuit breaker (D.F.).

### Detailed Description of the Invention

Systems of alarm intelligent treatment, in general, use models based on rules for emitting diagnostics of problems in the monitored equipments. This approach has two major problems: great quantity of rules and very high constant maintenance index due to modification in the grid topology.

The solution used by the present invention consists in an evolution of the conventional model for a model based on "general rules". Its application can be in computers networks, telecommunications networks, electrical grids, among others. Unlike the conventional model, where the rules are applied to specific equipments, generic rules are applied on equipments classes. In order to exemplify, instead of the rule is applied to a given transmission line, it is applied to all transmission lines. In order to allow the rules to be indeed generic, the system and method relies on the concept of connectivity, i.e., the rule does not mention the position of, for example, switches and circuit breakers of a given transmission line, but only if the transmission line is or is not connected to any energized equipment.

This new way of preparing the base of rules dramatically reduces the amount of rules. To take one example, it is estimated that about 20,000 rules would be necessary to model an entire electrical grid; already using generic rules, only 40 rules.

Generic rule consists of the following elements:
- Macros: they are functions that can be used by the rules, they prevent a lot of code is repeated within the rule base;
- Logical expression of the rule: expression that will be evaluated for each equipment belonging to a certain class;
- Attributes: they are complements of the diagnostic. The attributes are used to reduce de amount of rules. Instead of having several rules aiming to cover all possibilities involving attributes, we have a single rule and various attributes.

A rule example is disarming in a transmission line and attributes with impediment and reconnection unsuccessful, instead of generating rules of: disarming; disarming with impediment; disarming with reconnection unsuccessful; disarming with impediment and reconnection unsuccessful; the present invention provides a method where it is only necessary to generate the disarming rules of attributes individually, and the system automatically generates the combinations. This solution, besides ensuring a small number of rules, brings zero maintenance, i.e., no effort is required to keep the knowledge used by the system updated. Whenever the topology of the electrical grid is modified, the system automatically identifies and updates the topology model in which the base of generic rules is applied.

The present invention provides a method for performing real-time and automatic diagnostics of failures in equipments located in transmission and generation grids of electric power through rules called "generic rules". The method of the present invention combines rule-based reasoning with reasoning based on models and facilitates the construction of the knowledge base, in addition to reducing the need to update due to changes in the topology of the electrical grid. The method of the present invention provides a small number of rules necessary to model the problems in the electrical grid by allowing the same rule can be reused for various equipments.

The present invention provides a method where the generic rules are applied to classes of equipments and comprises the steps of:
i. checking if the equipment is connected (energized) or not connected;
ii. checking if the equipment was connected (energized) or not connected;
iii. inserting rule(s) and/or macro(s) and/or attribute(s) to equipment(s) and/or type(s) of equipment(s);
iv. generating diagnostics for each equipment E and for each rule R in equipment and for each attribute A in equipment through condition of existence and activation condition;
v. replacing the variables in the text(s) of diagnostic(es); and
vi. sending diagnostic(es).

The method can further comprise the following steps:
vii. remove diagnostic(es) with expired symptom(s);
viii. recover diagnostics with network's symptoms; and
ix. add symptoms in the associated equipment,
wherein said generic rules are applied on equipment classes, translating if the transmission line is or is not connected to any energized equipment.

Preferably, equipment can have several associated equipments and, in turn, associated equipment can have several associated equipments.

The method of the present invention preferably uses the Root Cause logic to recover diagnostics with symptoms on the network.

The method of the present invention preferably uses the Topological Primitives logic to inform the current topology of the grid in the generation of diagnostics.

The present invention also provides a system to perform real-time and automatic diagnostics of failures in equipments located in transmission and generation grids of electric power using rules called "generic rules". The system of the present invention combines rule-based reasoning with reasoning based on models and that facilitates the construction of the knowledge base, and in addition to reducing the need to update due to changes in the grid topology. The system of the present invention reduces the number of rules necessary to model the problems in the electrical grid by allowing the same rule to be reused for various equipments and comprises:
i) Means for generating the topology;
ii) Means for interconnecting networks;
iii) Means for maintaining a representation of the topology of the electrical grid;
iv) Means for generating diagnostics through generic rules based on collected data; and optionally,
v) Means for generating the screens of the diagnostics; and
vi) Means for generating reports.

The system of the invention can further comprise:
vii) Means for informing the availability of operation of each system module.

Preferably, said means for generating the topology are an embodiment called "Topogiggio", where it accesses the tables in the electrical grid management system, such as Sage (*Sistema Aberto de Supervisão e Controle* | *Open System of Supervision and Control)* and generates XML files containing the complete topology of the electrical grid.

Preferably, said means for interconnecting networks can be a Gateway, which accesses electrical grid management system, such as the Sage (*Sistema Aberto de Supervisão e Controle* | *Open System of Supervision and Control)* to retrieve in real time alarms, events, analog magnitudes and/or opening states of all circuit breakers and electrical grid switches.

Preferably, said means for updating the state of the topology can be an embodiment called "Model", which accesses the Gateway. It has a noise filter that evaluates whether the information retrieved from the system, being correct or not, if not, alarms or events are removed or inserted, so that the end the state of the topology is consistent.

### Generic Rules

The present invention provides a logic called "generic rules", which can be reused for all equipments of the same type. In order to make a generic rule, it must be parameterized to remove all references to specific components related to equipment which is being accomplished in the diagnostic. The parameterization of the rule takes place through the creation of topological parameters that correspond to each of the components of equipment on which it is being carried out the diagnostic.

As an example, the following topological parameters have been created:
- DJ1: corresponds to the circuit breaker which interrupts the connection between the first busbar to which the line is connected;
- DJ2: corresponds to the circuit breaker which interrupts the connection between the line and the second busbar to which the line is connected, if it exists;
- DJR: corresponds to the circuit breaker of the line reactor, if it exists;
- R: corresponds to the line reactor, if it exists;
- B1: First busbar to which the line is connected;
- B2: Second to which the line is connected, if it exists.

Thus, a line can be represented uniquely by its topological parameters enabling removal of any reference to specific components of the transmission line. The parameterization enabled the reduction of the rules of 1334 came to 51 rules in a transmission line. This parameterization has enabled the development of a rule for each type of problem of transmission lines thus generalizing their application to any equipment and/or part of the electrical grid.

In the case of a diagnositic in an electrical grid, more specifically a transmission line, the present invention is based on the following structure:
i. Main diagnostic
   1. Disarming
   2. Energizing
   3. Deenergizing
   4. Blackout
   5. Incorrect signaling of protection
ii. Type of main equipment
   1. LT
   2. LT Terminal
   3. Bank of capacitor
   4. Reactor
   5. Trafo winding
   6. Trafo
   7. Static compensator
   8. Synchronous compensator
   9. Series compensation
   10. Bar
   11. Generator
   12. Generator link
   13. Substation (to blackout)
iii. Identification of main equipment
   1. Ex. 04L2
iv. The location of the defect (to LT)
   1. Internal defect
   2. External defect
   3. Systemic defect
v. If the line is the concessionaire (to LT and LT terminal)
vi. If there was an attempt to automatic restart (to LT and LT terminal)
   1. If there was or was not success in restart (it is applied to each side of the LT)
vii. If lockout relay has worked
viii. The set of protections that have worked
   1. Including an indication of the equipment to which the protection chain belongs
   2. Include protection on each side of LT, when it is LT
   3. Include which winding is involved, when it is a trafo
   4. Indicate whether the protection is intrinsic or not
ix. If there was improper performance of protection
x. If there was failure in circuit breaker
   1. With the identification of the failed circuit breaker
xi. If there was a lack of protection performance

### Topological Primitives

Topological primitives are conceptual constructs that allow withdrawing from the event correlation rules all references to elements of the topology of electrical grid. With topological primitives, it is possible to isolate, diagnosing a problem, the information related to the topology associated with the equipment in question; this way the rule does not need to be changed if there is any change in the grid topology.

The topological primitives are based on analysis of the connectivity of a graph that represents all the connections between the different equipments present in the electrical grid. This graph is the contribution of model-based reasoning for the method. In addition to modeling the connections between network equipments, the graph also maintains the state of each equipment by processing the events received by the diagnostic system.

In the case one of transmission lines, the following topological primitives can be set for the rules:
- Connected (Line, Bar): reports whether a given line is connected to a given bar;
- Partial shutdown side from (Line): reports if the line is not connected to any of the source substation bars, but to some of the destination substation bars;
- Partial shutdown side to (Line): reports if the line is not connected to any of the destination substation bars, but to some of the source substation bars;
- Total shutdown (Line): the line is not connected to any bar.

Only with the insert of topological primitives, it is not possible to reuse a rule previously written to other equipments of the same type. So that the rules can be reused, it must be parameterized.

### Root Cause

Root cause analysis is a process designed to identify the initial cause of a sequence of related events, where a sequence of related events is a generic way to name events/failures that are part of the same occurrence. An occurrence is usually composed of primary events and secondary events. Primary event is called the root cause, or initial event, while secondary event is a consequence of a primary event and can be also considered as a symptom of the root cause.

If the analysis only identify the initial cause of the problem and stop at this point, the operator will not have enough information to understand, in fact, how all occurrence happened after the primary event, i.e., as the event spread, thus generating events secondary. This way, the analysis of root cause also aims to find an accurate description of what happened, that is, how the initial failure spread, causing other occurrence failures.

The analysis of root cause for failure occurrences in electrical systems identifies what happened (root cause) and how it happened (propagation), where the method must meet some basic requirements to ensure its effectiveness:
- The method should be automatic, requiring no effort to adapt to topological changes, i.e., "zero maintenance";
- The method should be efficient: complexity acceptable for big occurrences;

### Process of Root Cause Analysis

The method comprises relations of topology/flow, time and diagnostic concepts of the elements. The considered elements are lines, transformers, busbars, circuit breakers and others.

The knowledge used as the basis of the definition of the method is energy flow relationship between system elements. The direction of energy flow defines how the electric power moves physically around all electric system, thus defining the way how it spreads from one element to another.

Intuitively, the flow of energy of an element X to an element Y generates a dependency of Y relative to X, i.e., the element X is the energy source (input) to the element Y, which is the destination (consumer) of energy, where Y depends on X to get energy. In order to Y get energy, it needs that X is working properly, then a failure in X could cause a failure in Y.

Following the same reasoning of energy spread to the propagation of failure is the initial way to address problem of analysis of root cause. For this, one only model based on energy flow was built. Next, new knowledge has been incorporated into the method to refine and improve the model, thus generating a new consistent and validated model. The new knowledge is represented in the form of filters, alarm propagation rules and timing alarms. In this way, the new model represents the combination of this knowledge, and also the answer to the 'what' happened and 'how' it happened, and thus, the end product of the system and method of the invention.

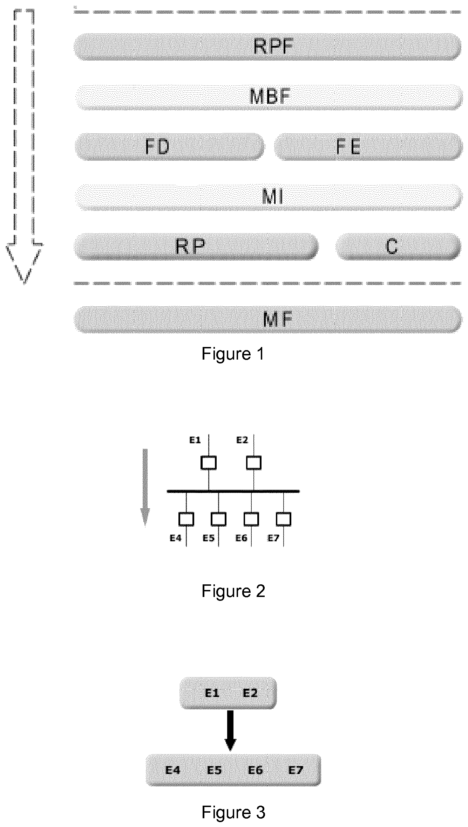

Figure 1 illustrates the sequence of knowledges applied to generate the model that can identify the root cause to the failure and spread. The system and method of the invention takes as input the occurrence of failure in the electrical system in the form of alarms, and needs information about the system topology, so that with propagation flow relations previously defined, generates a model of flow propagation of the system with occurrence elements in the form of a graph; the model then passes through a series of filters where it is prepared for the final stage where the rules of alarm propagation correct and validate the model, as well as the timing in certain cases.

### Topology/Flow Relations

The objective is to identify flow relations from one element to another. The following relations are defined:
- X → Y: Element X provides energy to the element Y.
- X ← Y: Element X receives energy from Y.
- X = Y: Elements X, Y receive energy from a same source, or provide to a same destination.

For example, consider figure 2**Errore. L'origine riferimento non e stata trovata.** with a topological configuration of elements from electric system, where the arrow indicates the energy flow direction.

It can be established the following relations:
- E1 = E2; E4 = E5; E4 = E6;...; E5 = E6; E6 = E7
- E1 → E4; E1 → E5; E1 → E6; E1 →E7
- E2 → E4; E2 → E5; E2 → E6; E2 →E7
- E4 ←E1; E4 ←E2;...; E7 ← E1; E7 ← E2

Relations are established between pairs of elements that are part of the occurrence, and it is possible to build a tree-shaped model (or graph) with all occurrence failures, as the model of Figure 3, where elements considered equal with respect the flow share the same level (E1 and E2 in the first level and E4, E5, E6, E7 in the second level).

The model is generated automatically whenever an occurrence happen. The way the model is built is a similar approach to sorting algorithms, where pairs of elements are compared and sorted, building the model incrementally. With this approach, this step has a complexity of *O*(*nlog*(*n*)).

First of all using the flow knowledge also serves as a filter to ensure that failures outside the occurrence, but that have been included because of the temporal proximity with others, are eliminated. It is considered here that there is no relationship of a failed element with no other element of the occurrence, the failure would have no way to propagate it, therefore being a noise.

### Filters

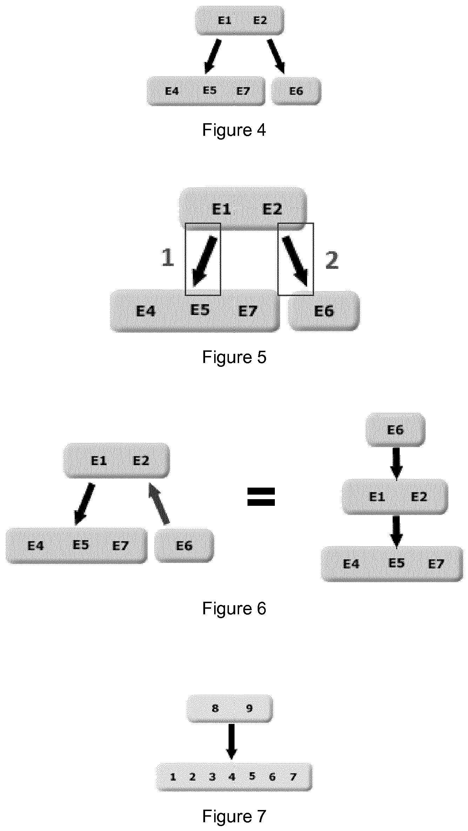

The main objective of the filters is to prepare the template for the next validation step with timing and alarms propagation rules. One embodiment includes the separation of the model elements by diagnostic (type of alarm). Another embodiment includes the separation by type of elements (transformers, lines, etc.). For example, considering figure 4, that illustrates the model of figure 5 after separation of elements by diagnostic: The result is a model where the type of diagnostic E1 is equal to E2 (ex., *Deenergized*); E4, E5 e E7 also have the same type of diagnostic (ex., *Deenergized*), and the element E6 that before was part of the same group of E4, E5 e E7 by flow definition, should now belong to a new group, because it differs regarding the type of diagnostic (i.g. *disarming*) with the rest of its group, however, maintains the same flow relative.

### Diagnostic Statistics

In order to improve the quality of diagnostics, system and method of the present invention were developed. In one embodiment, to facilitate preparation and understanding of the diagnostic rule, new rules called "generic rules" were prepared in which the primary diagnostic is separated from the attributes associated with this.

**Statistics on the tests of the new rules:**

| Statistics | **Old Version** | **New Version** |
|---|---|---|
| Correctly flagged diagnostics | 520 | 564 |
| System bug | 5 | 0 |
| Incorrect diagnostics of line de-energizing on busbar disarming | 30 | 0 |
| Equipment under maintenance | 224 | 102 |
| Remote under maintenance | 71 | 17 |
| Incorrectly flagged circuit breaker opening event | 8 | 6 |
| Incorrectly flagged circuit breaker opening and closing event | 7 | 1 |
| Incorrectly flagged protection and opening event | 5 | 5 |
| Incorrectly flagged circuit breaker closing event | 5 | 5 |
| Not flagged protection event | 2 | 2 |
| Incorrectly flagged protection event | 2 | 1 |
| Incorrectly flagged protection event and very low electrical magnitudes (noise occurred only in two lines) | 698 | 0 |
| Not flagged closing event | 1 | 0 |
| Incorrectly flagged diagnostics during *bypass* | 22 | 6 |
| Problem in rules basis | 5 | 0 |
| Total diagnostics | 1605 | 709 |
| Corrects | 32% | 80% |
| Corrects ignoring equipments/remotes under maintenance | 40% | 96% |

### EXAMPLES

The examples shown herein are intended to illustrate only one of many ways of performing the invention, but without limiting the scope thereof.

### Description of topology of electrical grid

Equipment: represents any equipment of electrical grid. There are two types of equipments:
- Sectioning equipments: switches and circuit breakers
- Non-sectioning equipments: busbars, transformers, lines, capacitor bank, generators, synchronous condensers, static compensators and windings.

Every equipment is associated to one or two terminals. A terminal connects an equipment to a connectivity node that is in turn associated with various terminals. In this way, the path that connects a equipment to another goes through terminals and connectivity nodes.

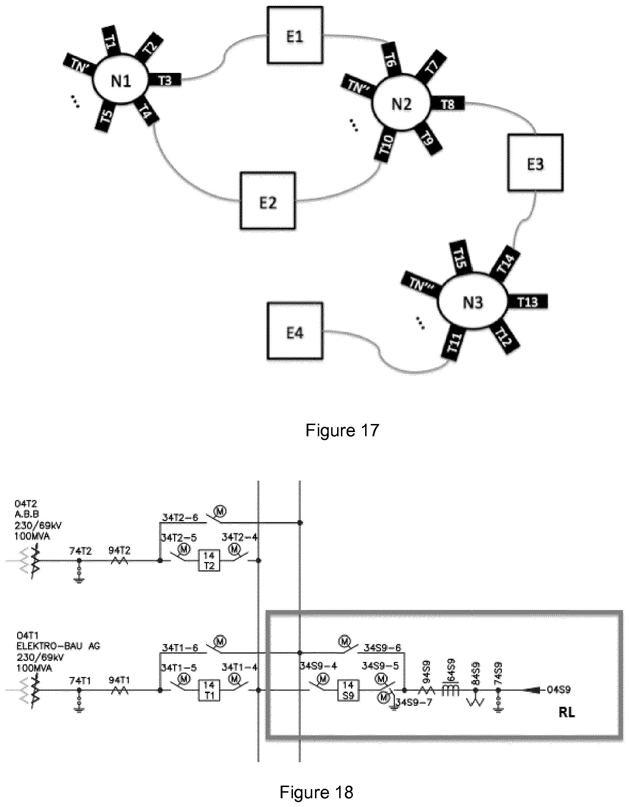

Figure 17 illustrates a topology containing four facilities, three nodes connectivity. The equipments are represented by squares, while the nodes by circles. The equipment E1 has two terminals: T3 and T6. The terminal T6 is associated to the connectivity node N2, which has many terminals, among them, the terminals T6, T7, T8, T9 e T10. It is noticed that the equipment E1 is connected to the equipment E4 through the following path:
- E1 to T6 to N2 to T8 to E3 to T14 to N3 to T11 to E4

The equipment E1 is only connected to the equipment E4 if there is at least one way to keep them connected, wherein all sectioning equipments are closed. This was, if the equipment E3 is open, E1 is not connected to the equipment E4.

### Attributes and methods associated to topology

The representation of the equipment of the electrical system is based on an object-oriented model, which means that each machine has attributes and methods to get the status of the equipment or manipulate the equipment in some way.

The following classes are used by solution:
- Equipment: represents any topology equipment;
- Conductive Equipment: represents an Equipment that transfers energy;
- Sectioning Equipment: represents an Equipment that interrupts energy (it may be a circuit breaker or switch);
- Transmission line: represents a transmission line. A line has at least one terminal of transmission line. In general, a line has two terminals of transmission line;
- Terminal of Transmission line: represents a terminal of a transmission line;
- Reactor: represents a reactor;
- Transformer: represents a transformer;
- Capacitor Bank: represents a capacitor bank;
- Synchronous Compensator: represents a synchronous compensator;
- Static Compensator: represents a static compensator;
- Generator: represents a generator;
- Switch: represents a switch;
- Circuit breaker: represents a circuit breaker.
   Class: Equipment

### Attributes:

- Code: equipment code
- Type: type of equipment.
- Possible types: circuit breaker, bar, generator, switch, synchronous compensator, static compensator, reactor, earth trafo, transmission line, terminal of transmission line, transformer, winding, substation.
- Substation: substation in which the equipment is inserted
- Measures: it contains all possible measures of an equipment
- Measure examples are: MW, MVar, kV, A
- Events: list of recovered events in the network.
- Voltage: voltage level of the equipment.
   Class: Conductor Equipment (extends equipment)

### Attributes

- Terminals: list of equipment terminals

### Methods

- someCircuitBreakerThatWasOpenHasComeToCloseAndOpen (): it evaluates whether a circuit breaker that can protect the equipment was open and came to close and open the last 30 seconds.
- someCircuitBreakerHasReconnectedSuccessfully (): it evaluates whether some circuit breaker that is protecting the equipment has opened and has closed.
- someCircuitBreakerHasReconnectedUnsuccessfully (): it evaluates whether some circuit breaker that was protecting the equipment has opened and has closed.
- someCircuitBreakerHasReconnected (): it evaluates whether some circuit breaker that was or is protecting the equipment has reconnected with or without success.
- someCircuitBreakerWithFailureEvent (): it evaluates whether some circuit breaker that was or is protecting the equipment has received a failure event of the circuit breaker recently.
- someCircuitBreakerHasFlagged(): it evaluates whether some circuit breaker that was or is protecting the equipment has received any event recently.
- someCircuitBreakerHasOpened(): it evaluates whether some circuit breaker that was protecting the equipment has opened and is still open.
- someCircuitBreakerHasClosed(): it evaluates whether some circuit breaker that is protecting the equipment has closed and is still closed.
- isEnergized(): it evaluates whether the equipment is energized
- wasEnergized (): it evaluates whether the equipment was energized
- isolated(): it evaluates whether the equipment is not energized
- wasisolated(): it evaluates whether the equipment was not energized
- hasDefectEventslnRelatedBusbars
- ProtectionClassWasFlaggedInSomeRelatedBar (Protectionclass): it checks for any event associated to the busbar with the class protection passed by parameter.
- ProtectionClassWasFlagged(Protectionclass): it checks if exists any event with the protection class passed by parameter.
- someProtectionWasFlagged (): it informs if any protection event related to equipment was flagged
- hasDefectEvents(Defecttype):
- ProtectionclassShouldBeDisplayed(): some protection classes can be hidden for operators, this method informs whether exists any event whose protection class should not be hidden.
- equipmentIsUnderMaintenance(): it informs whether the equipment is under maintenance (open switches).
   Class: SecctioningEquipment (extends ConductiveEquipment)

### Methods

- isOpen(): it informs whether the equipment is open
   Class: TranmissionLine (extendes ConductiveEquipment)

### Attributes

- from: terminal source side of the transmission line
- to: terminal destination side of the transmission line

### Methods

- ehLink(): it informs the line is a link to a generating unit
   Class: TerminalOfTransmissionLine (extends ConductiveEquipment)

### Attributes

- r: reactor of terminal of transmission line
- d1: main circuit breaker of terminal of transmission line
- d2: *bypass* circuit breaker of terminal of transmission line
- bar1: main busbar used by the terminal of transmission line
- bar2: secondary or auxiliary bar used by terminal of transmission line

### Methods

- ehLink(): it informs the line represents a link for a generating unit
   Class: Reactor (extends ConductiveEquipment)

### Attributes

- dr: circuit breaker reactor

### Methods

- ehLink():it informs the line represents a link for a generating unit
   Class: Transformer (extends ConductiveEquipment)

### Attributes

- enro13kV: winding of 13kV (if exists)
- enro69kV: winding of 69kV (if exists)
- enro138kV: winding of 138kV (if exists)
- enro230kV: winding of 230kV (if exists)
- enro500kV: winding of 500kV (if exists)

### Methods

- ehTrafoElevador(): it informs if the transformer is of elevator trafo type
- someWindingWasDeenergized(): it informs if some winding of the transformer was Deenergized
- someCompensatorCircuitBreakerHasOpenedorFailed(): it informs if some compensator circuit breaker has opened or failed
- primaryWindingHasFailed(): it informs if the circuit breaker of primary winding of the transformer has falied
- secondaryWindingHasFailed (): it informs if the circuit breaker of secondary winding of the transformer has failed
- terciaryWindingHasFailed (): it informs if the circuit breaker of terciary winding of the transformer has failed
- allWindingsAreEnergized(): it informs if all windings of the transformer are energized
- allWindingsWereEnergized(): it informs if all windings of the transformer were energized
- allWindingsAreDeenergized(): it informs if all windings of the transformer are Deenergized
- allWindingsWereDeenergized (): it informs if all windings of the transformer were Deenergized
- someCircuitBreakerOfPrimaryWindingHasFailed(): it informs if some circuit breaker of the primary winding has failed
- someCircuitBreakerOfSecondaryWindingHasFailed (): it informs if some circuit breaker of the secondary winding has failed
- someCircuitBreakerOfTerciaryWindingHasFailed (): it informs if some circuit breaker of the terciary winding has failed
- CircuitBreakerOfStaticCompensatorsHaveOpenedorFailed(): it informs if all circuits breakers of static compensator has opened or failed

### Class: Winding (extends ConductiveEquipment)

### Attributes

- t: transformer in which the winding is part
- djc: circuit breaker of compensator, if exists
   Class: Substation (extends ConductiveEquipment)

It does not have attributes or essential methods for the understanding of the solution.
Class: CapacitorBank (extends ConductiveEquipment)

### Attributes

- djbc: circuit breaker of capacitor bank
   Class: SynchronousCompensator (extends ConductiveEquipment)

### Attributes

- djcs: circuit breaker of synchronous compensator
   Class: Generator (extends ConductiveEquipment)

### Attributes

- link: terminal of transmission line that represents the link

### Methods:

- mwDroppedSharply(): it informs if the mw dropped sharply. This decrease occurs when the power reduces to a value greater than 53 MW to a value less than 3 MW.
   Class: StaticCompensator (extends ConductiveEquipment)

### Attributes

- djce: circuit breaker of static compensator
- trafo: transformer that is associated with compensator
   Class: Busbar (extends ConductiveEquipment)

### Attributes

- otherBusbar: associated busbar that can be used to transfer
- Barnumber: it informs the busbar number (it can be 1 ou 2)

### Methods

- ehAuxiliary(): it informs if the busbar is auxiliary
- almostAllTrafoAndLineCircuitBreakersHasOpenedoOrFailed(): in caso more than 70% of the circuit breakers have opened or failed in the same second. In case this number is less than 2 (extracted minimum number based on a set of experiments), 2 will be returned.
- isNormallyEnergized(): it informs if the busbar is normally energized. Main busbars usually generally can be found energized, while the auxiliaries cannot.
- actuatedSomkeEarthTrafoProtection(): it informs if actuated some protection associated to earth trafo.
   Class: Switch (extends Equipmentseccionável)

All attributes e important methods for the understanding of the solution are in Sectioning equipment
Class: Circuit breaker (extends Equipmentseccionável)

### Attributes

- isOpen
- isBypassed

### Methods

- ehCentralCircuitBreaker(): it informs if it is the central circuit breaker in a um arrando of circuit breaker and half.
- wasBeingUsed(): it informs if the circuit breaker is being used or not. A circuit breaker is being used when it is protecting an equipment.

### Introducing an example of a diagnostic rule for alarm trigger

An alarm trigger rule has the following attributes:
- type: type of diagnostic, it can assume the following values:
   ∘ BLACKOUT
   ∘ ENERGIZATION
   ∘ ENERGIZATION_SIDE_FROM
   ∘ ENERGIZATION_SIDE_TO
   ∘ DEENERGIZATION
   ∘ DEENERGIZATION_SIDE_FROM
   ∘ DEENERGIZATION_SIDE_TO
   ∘ DISARMING
   ∘ DISARMING_SIDE_FROM
   ∘ DISARMING_SIDE_TO
- code: rule code (it cannot be more than one rule with the same code)
- title: Diagnostic text to be presented to the operator. The following variables can be used in diagnostics title; they will be replaced with the correct values at creation time of diagnostic.
   ∘ ID: Equipment code
   ∘ DJS_WITH_FAILURE: code of circuit breakers that have failed
   ∘ REACTOR_DISARMED: code of reactors that have disarmed
   ∘ EARTH_TRAFOS_DISARMED: code of earth trafos that have disarmed
   ∘ PROTECTION_CLASSES: list of protection classes that have acted
   ∘ PROTECTION_CLASSES_SYSTEMIC_DEFECT: list of protection classes that had actuated protections whose type of defect is systemic
   ∘ PROTECTION_CLASSES_REACTORS: list of protection classes that had actuated protections related to reactors
   ∘ PROTECTION_CLASSES_EARTH_TRAFOS: list of protection classes that had actuated protections related to earth trafo
   ∘ SIDE_FROM: code of substation of source side of a transmission line
   ∘ SIDE_TO: code of substation of destination side of a transmission line
   ∘ BAR1: code da bar 1 do terminal de um transmission line
   ∘ BAR2: code of bar 2 of terminal of a transmission line
   ∘ ENRO: code of winding of a transformer
   ∘ DJ_REACTOR_WITH_FAILURE: code of circuit breaker (of reactor) that has failed
- evaluation expression: logic expression which evaluates whether the diagnostic should be issued or not (more details will be presented in next sections)
- existence expression: logic expression which evaluates whether the rule should be evaluate or not to generate a diagnostic.

### The language of the generic rules

The definition of the language used to develop alarms generic rules uses a grammar in Backus-Naur Form. A line starting with // is a comment and serves only to provide explanations or yesplify the reading of the grammar.

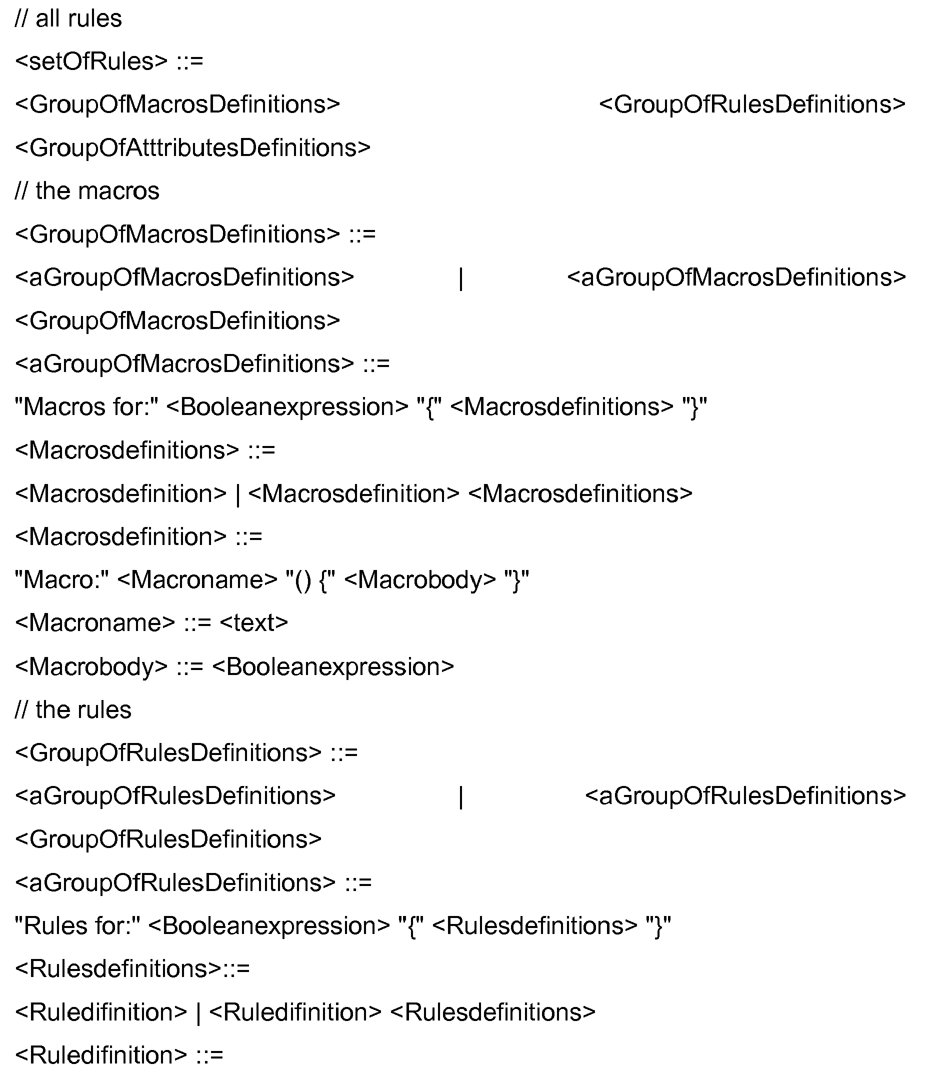

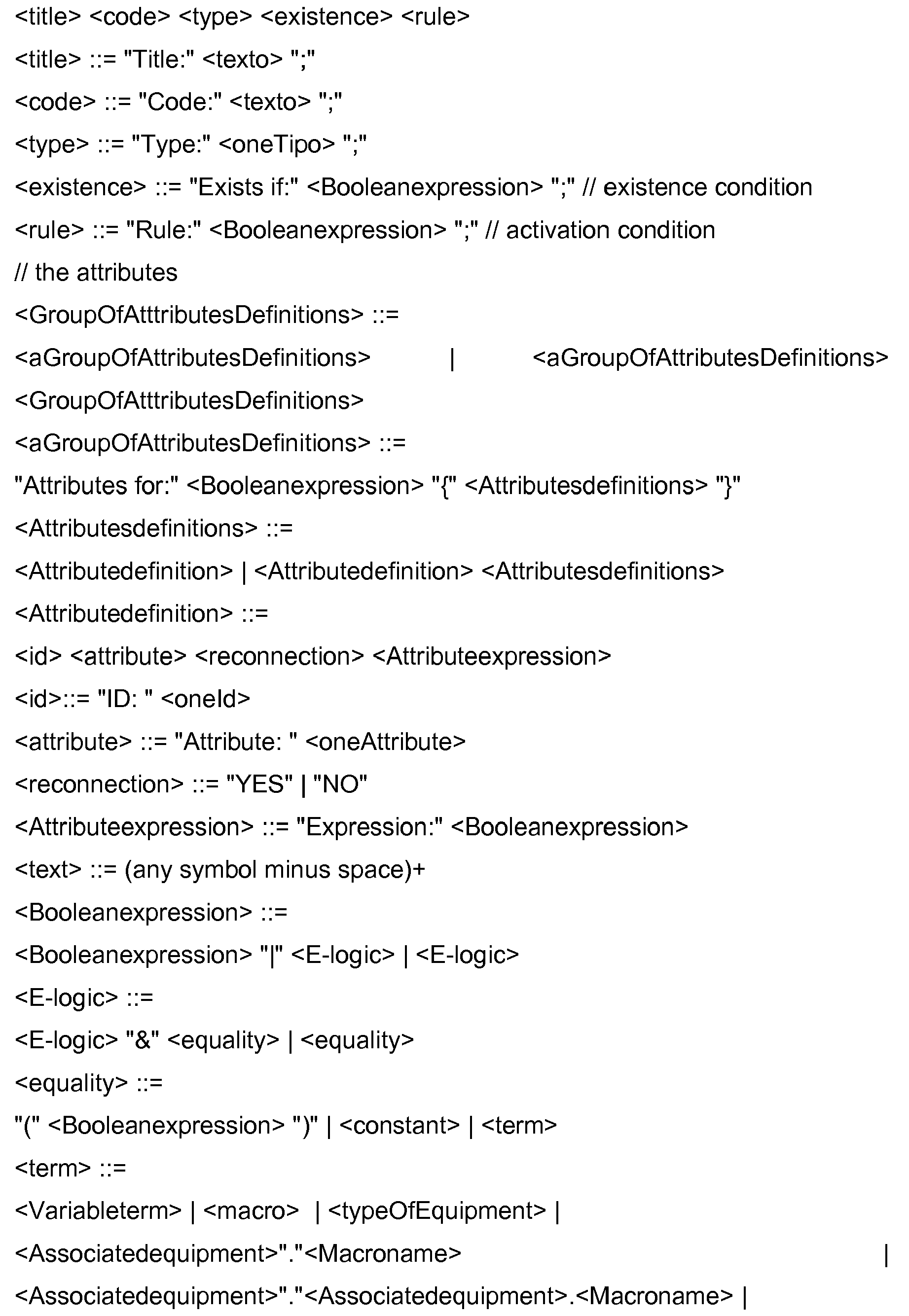

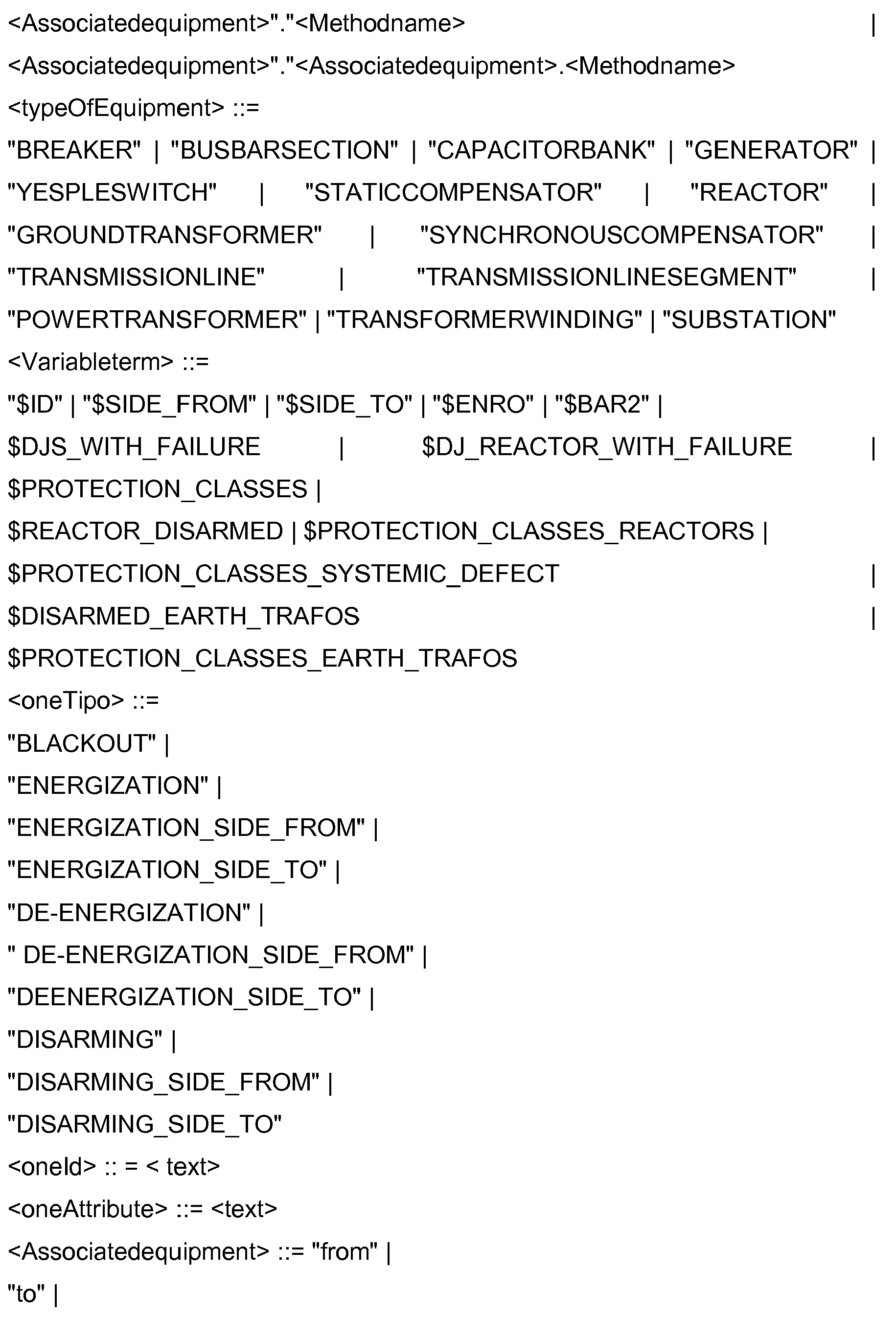

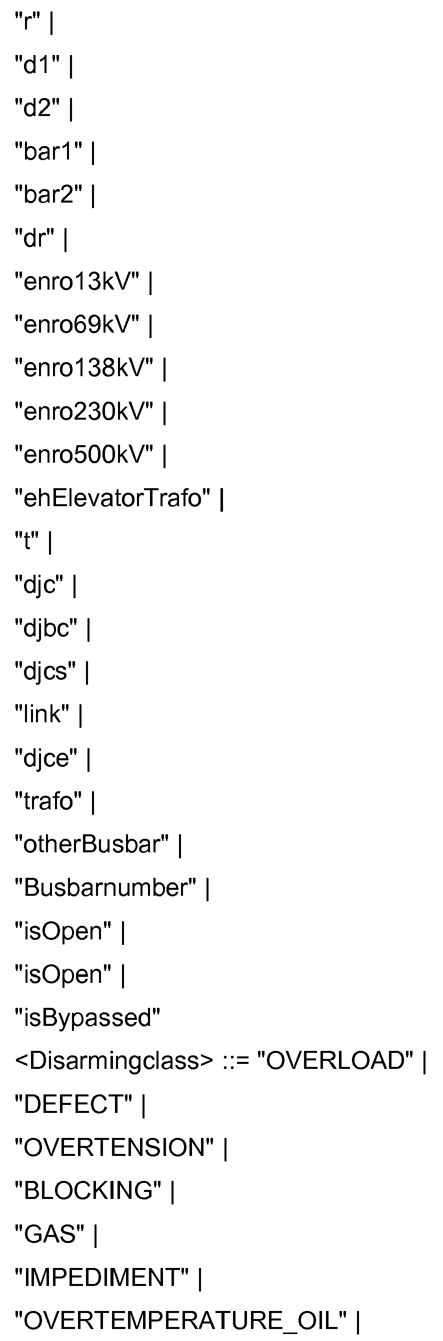

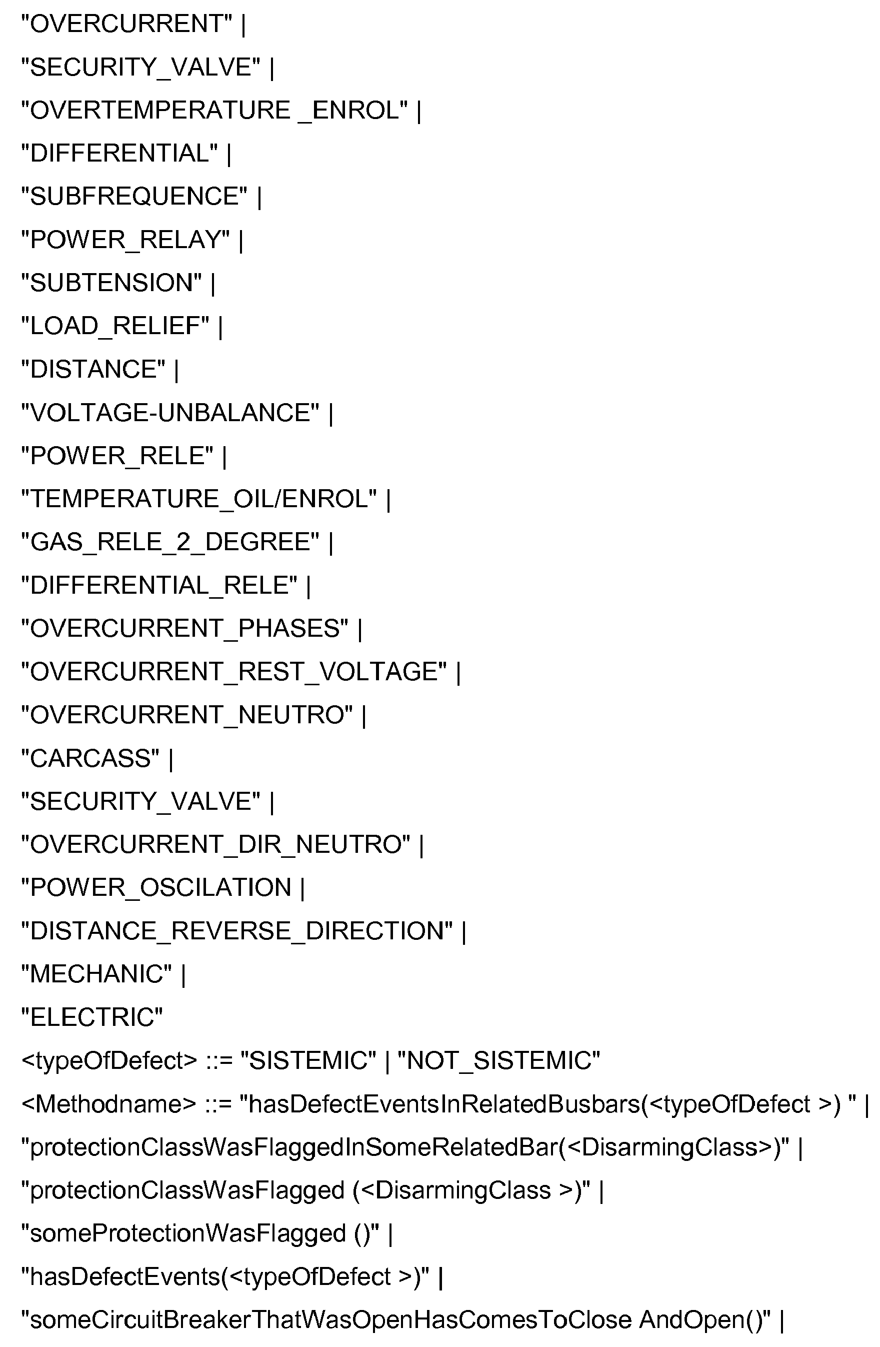

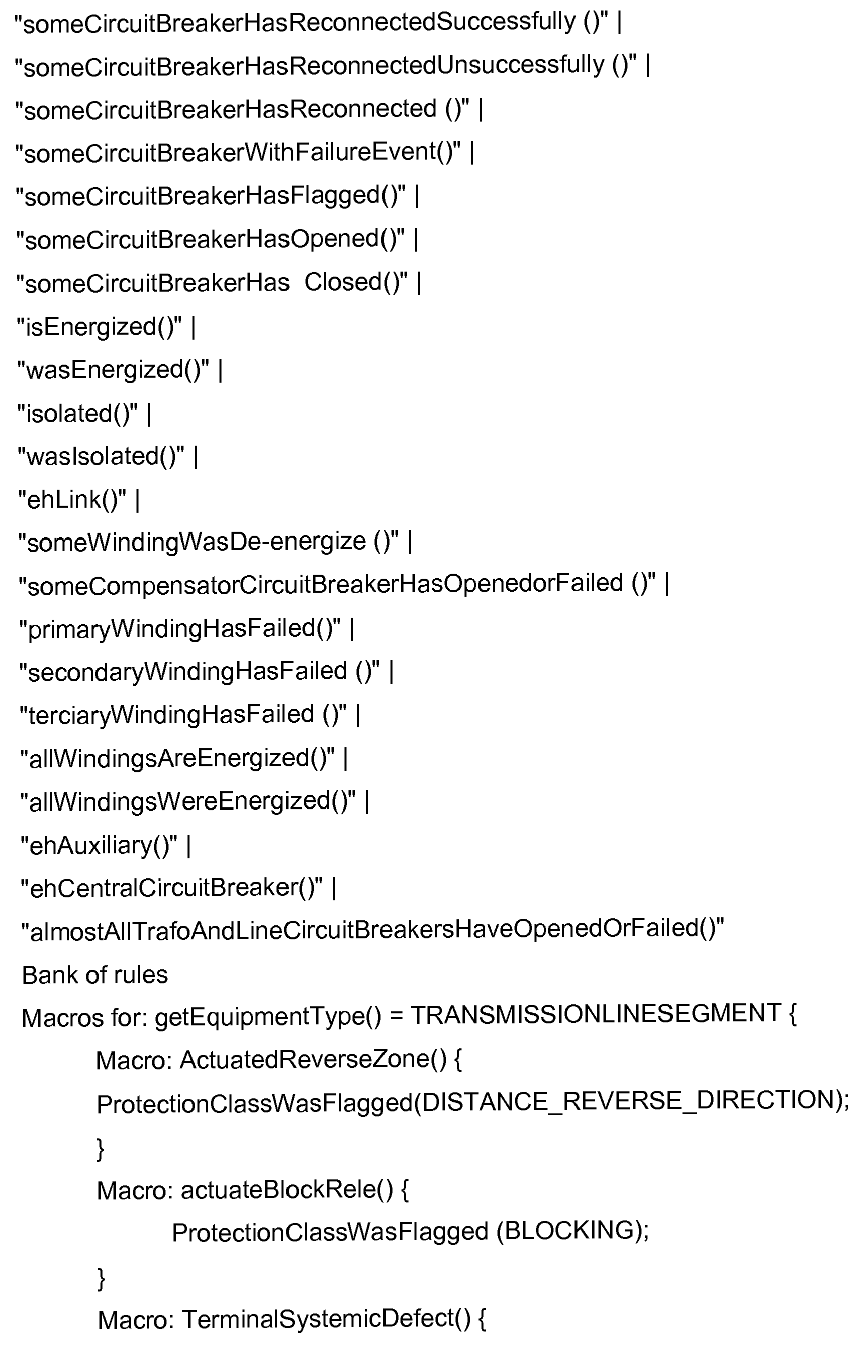

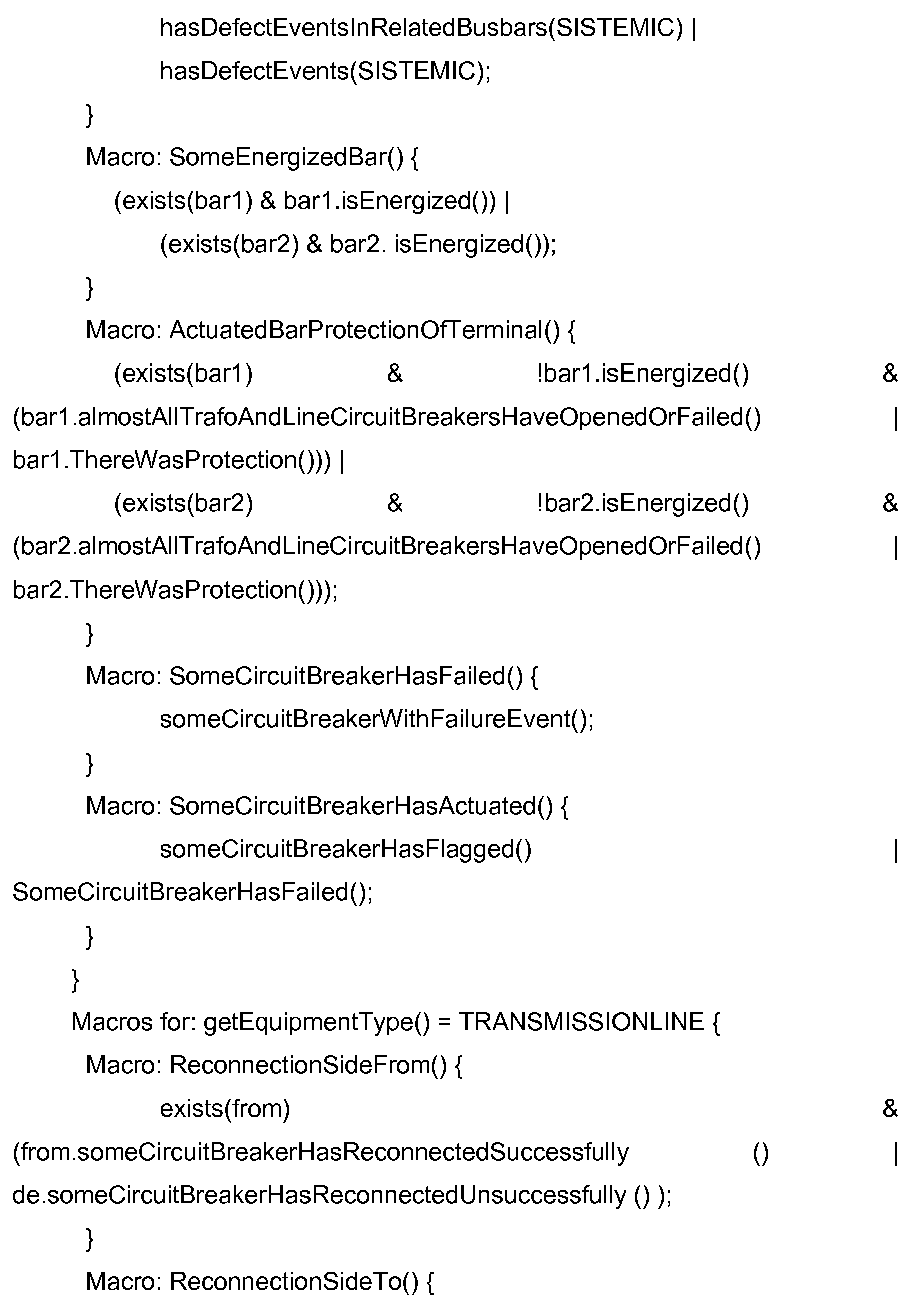

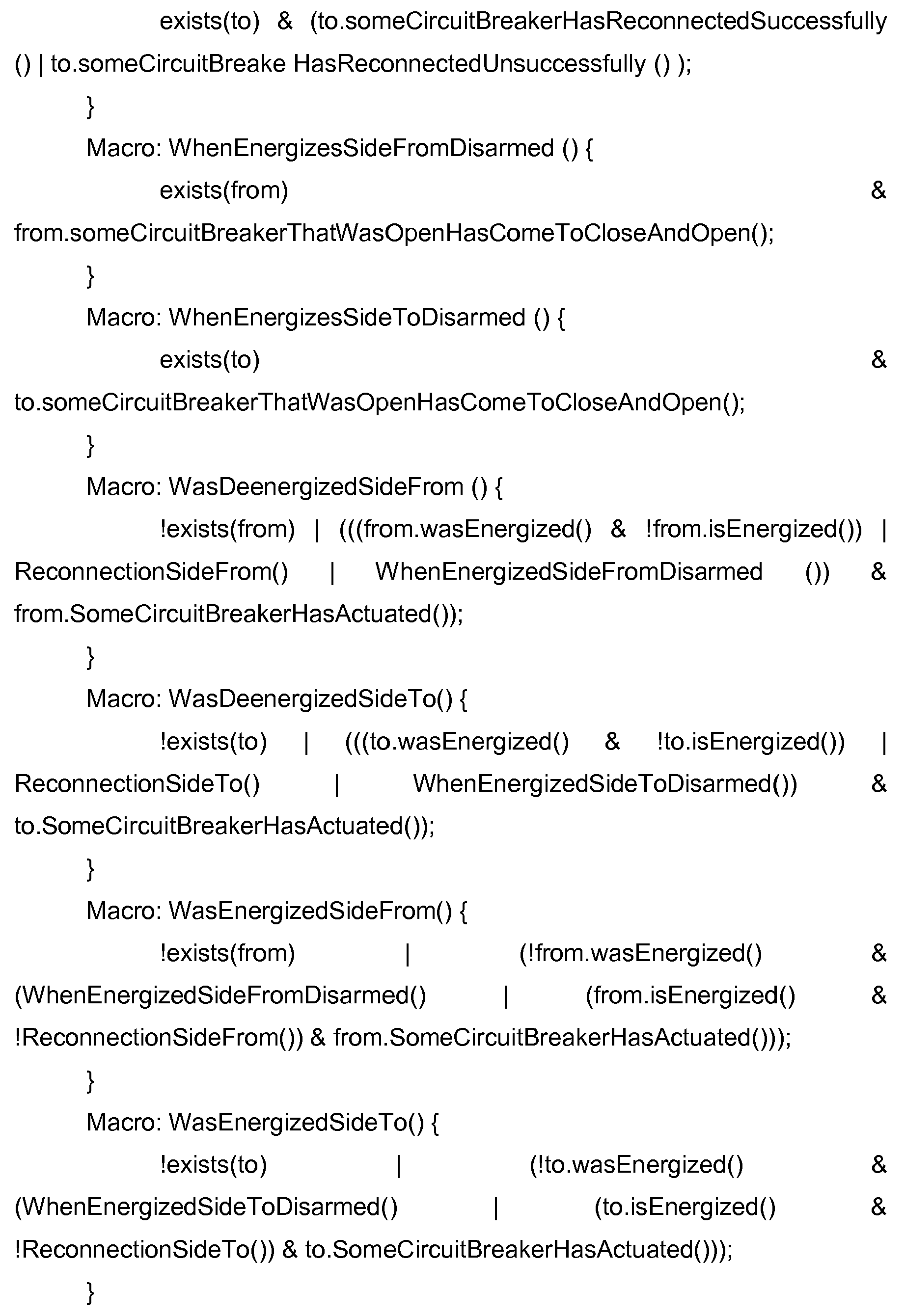

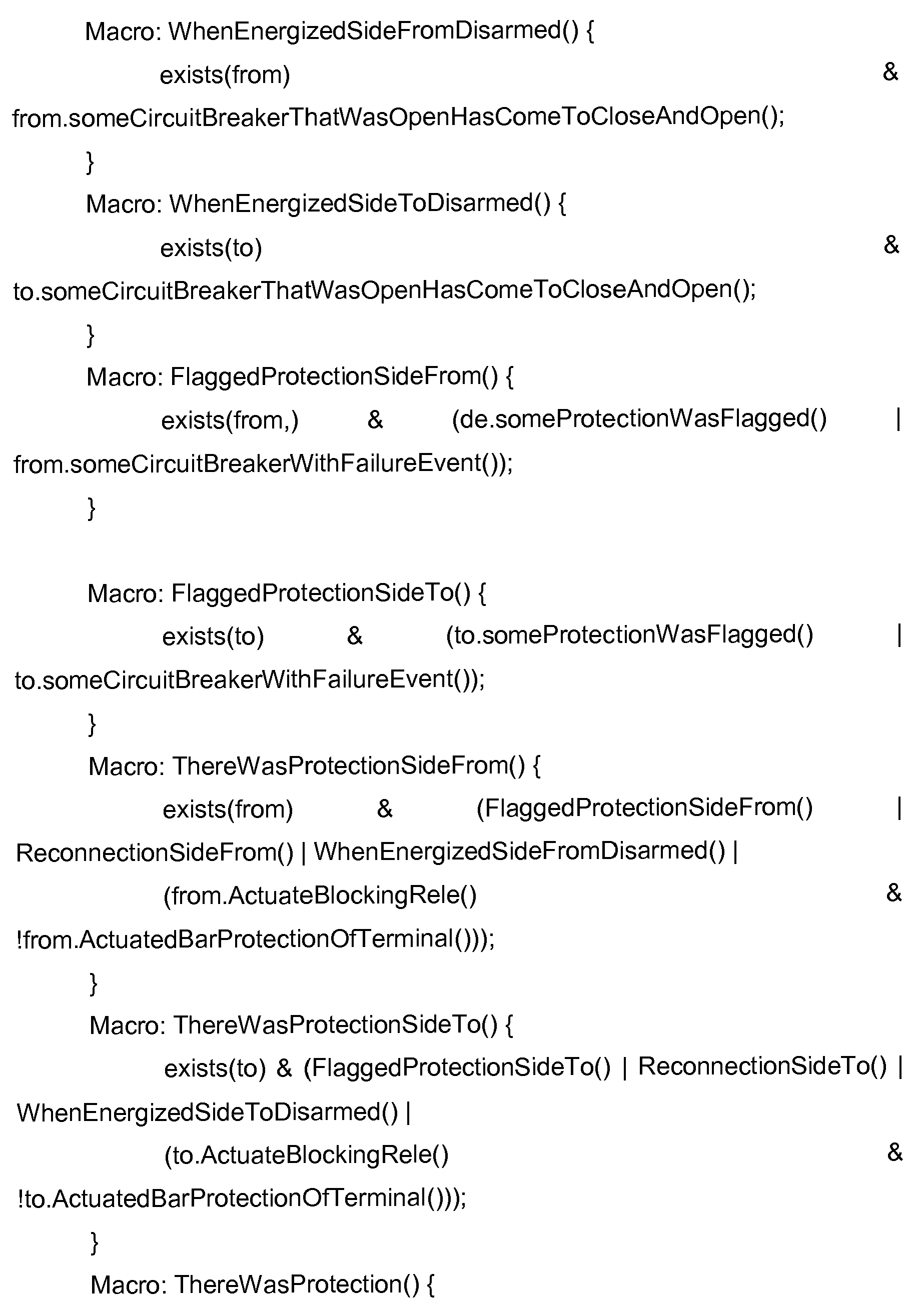

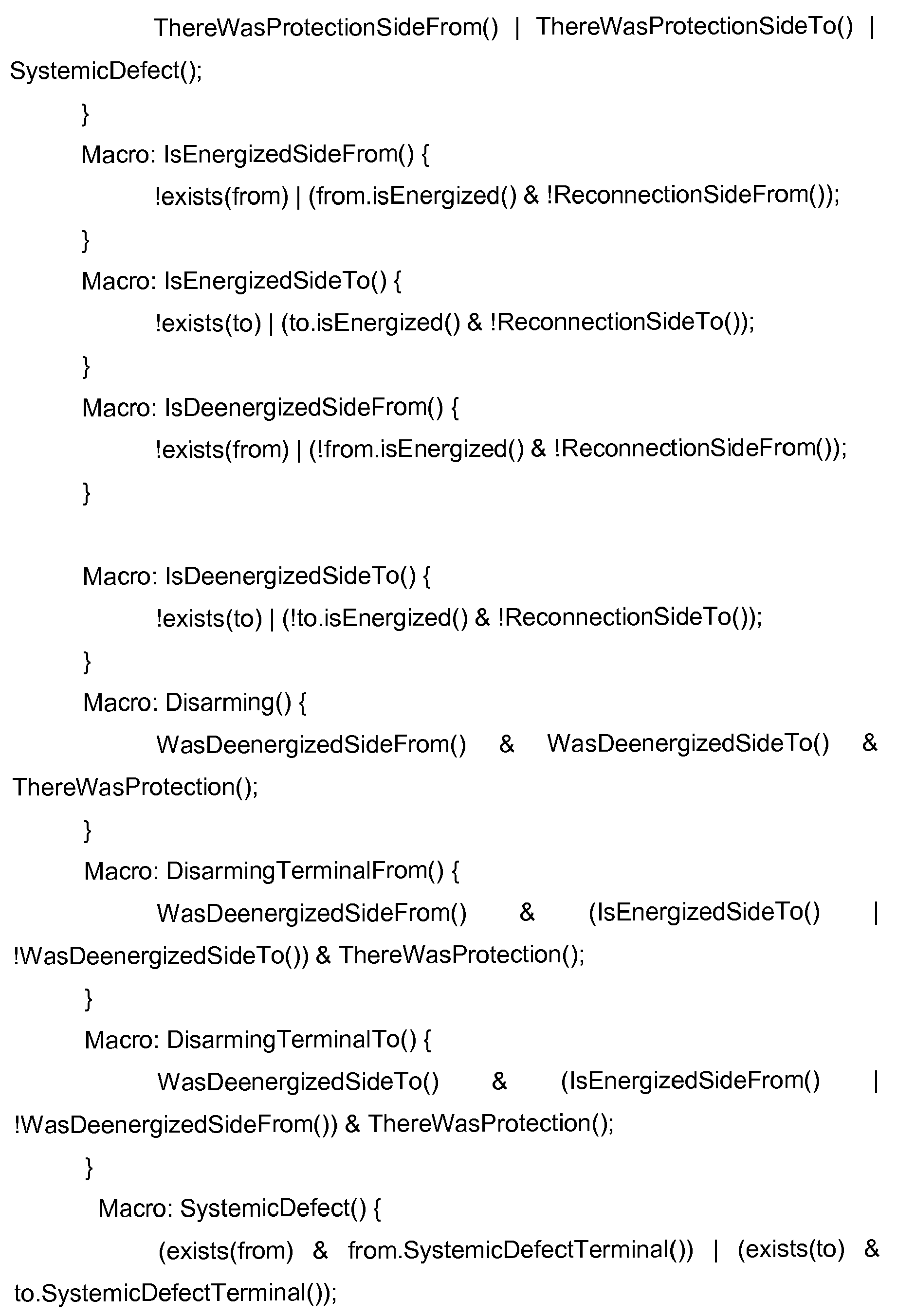

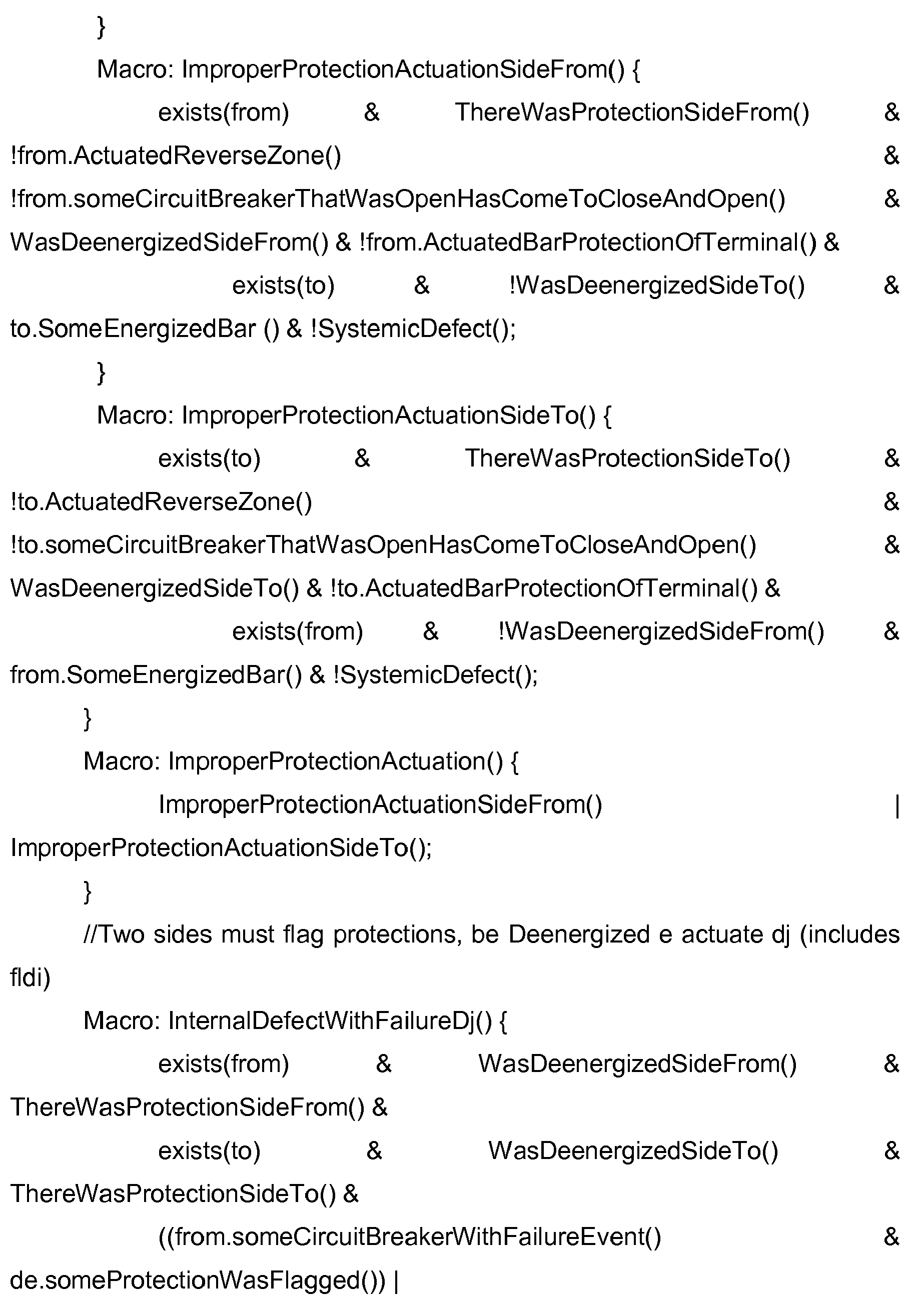

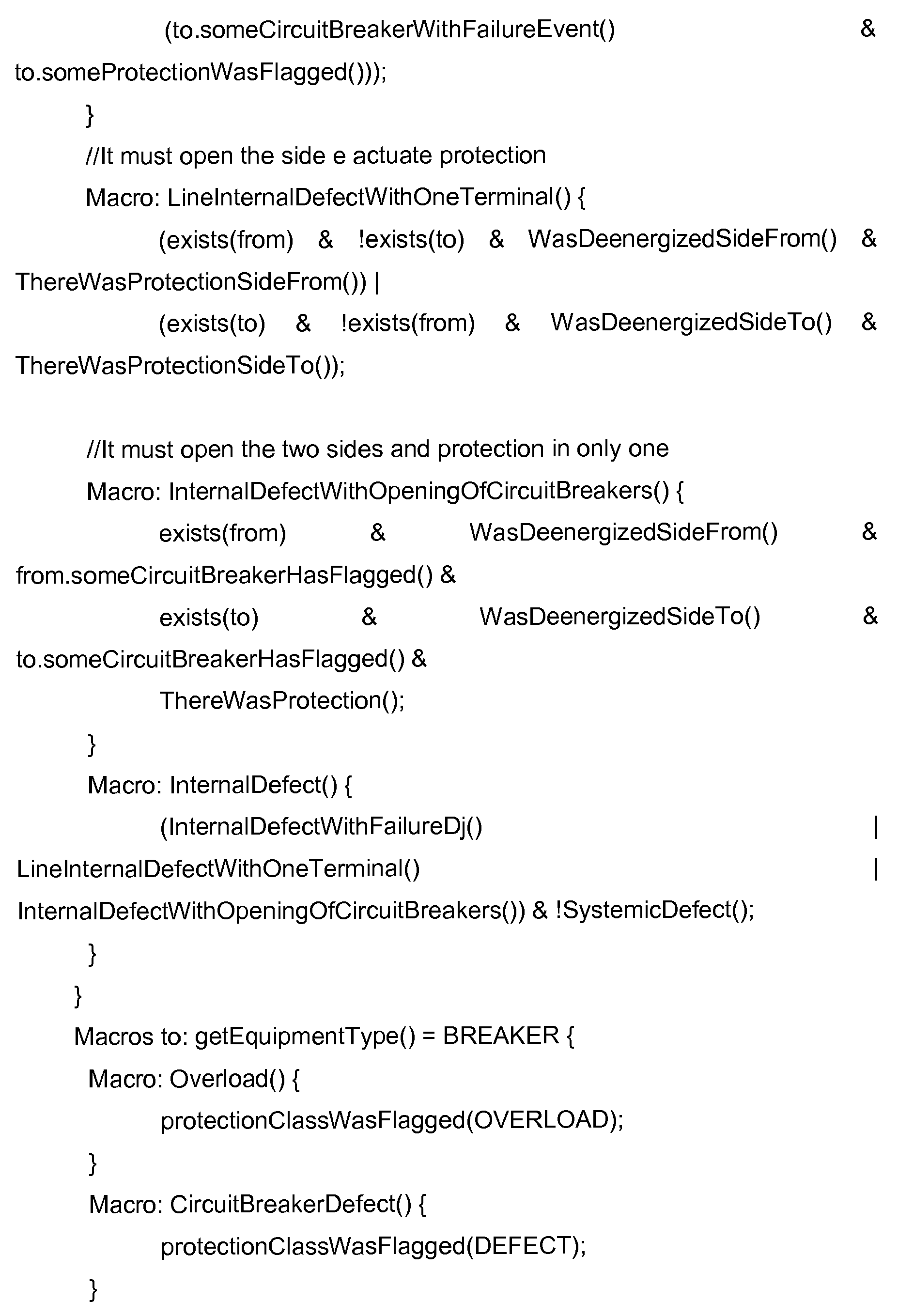

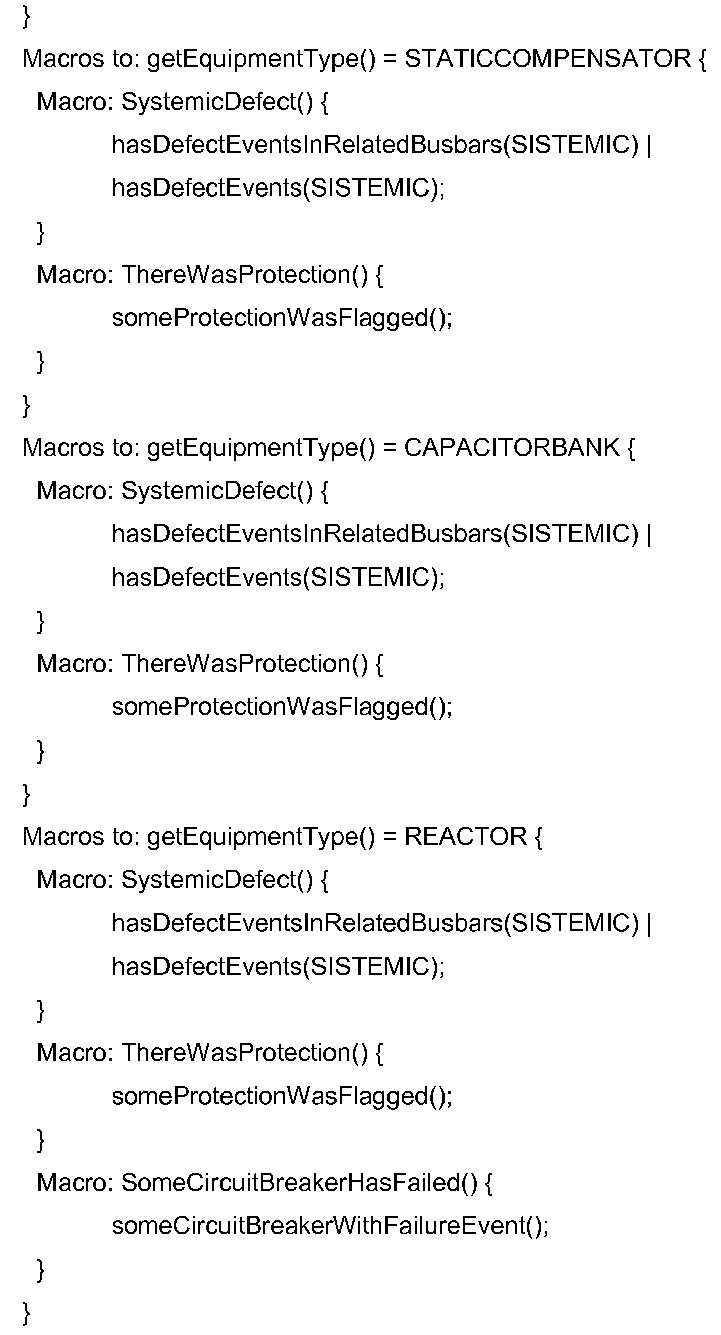

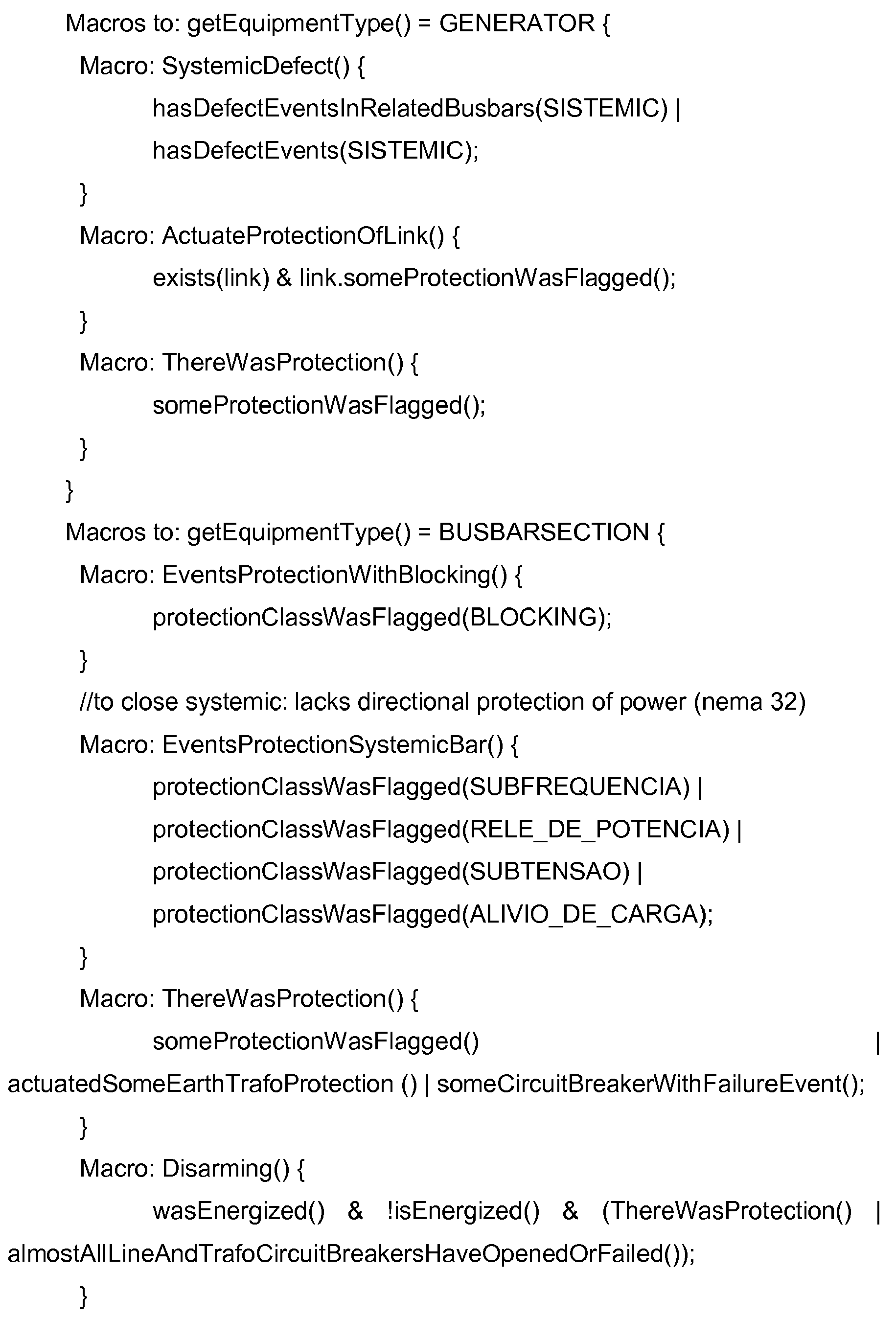

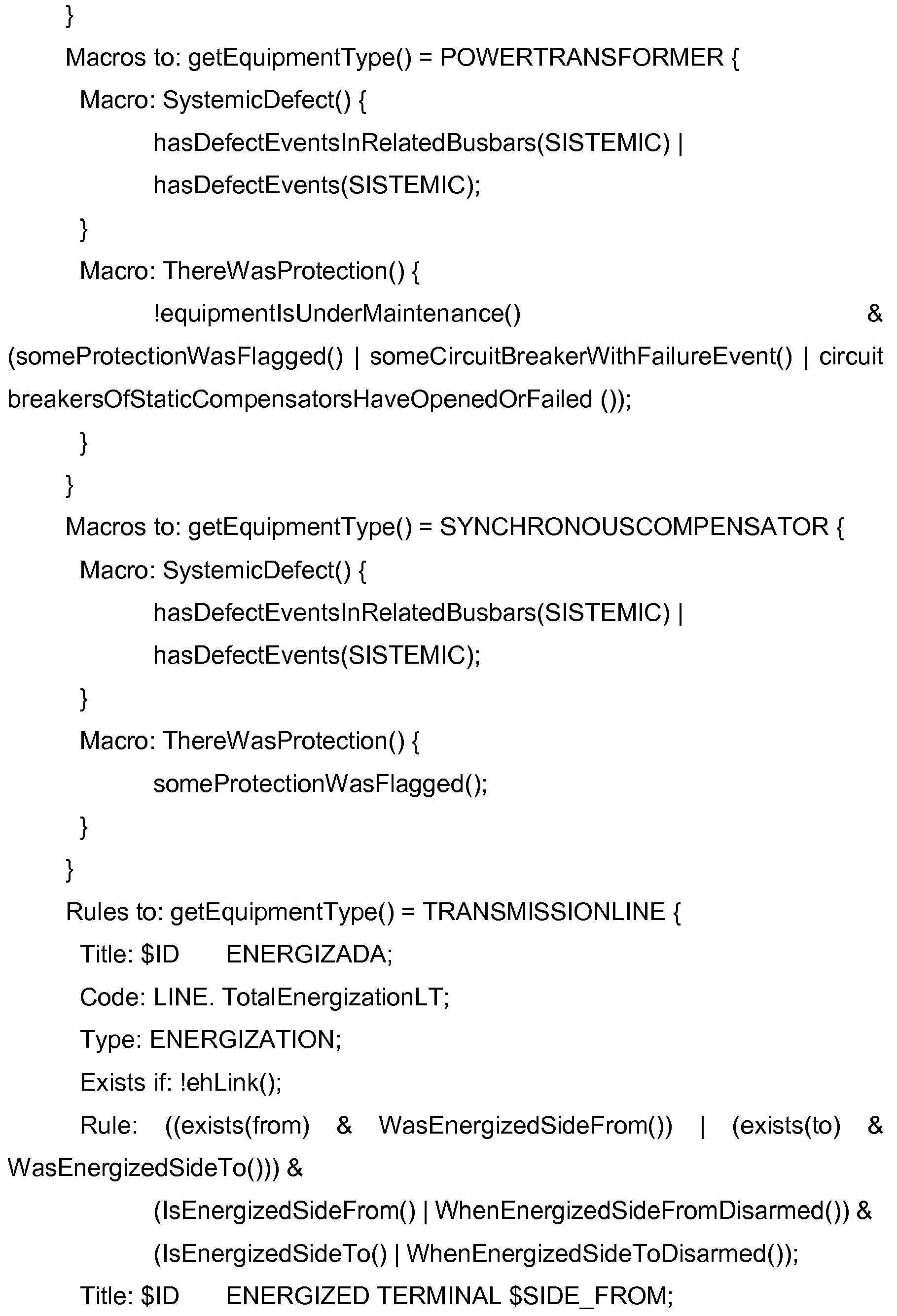

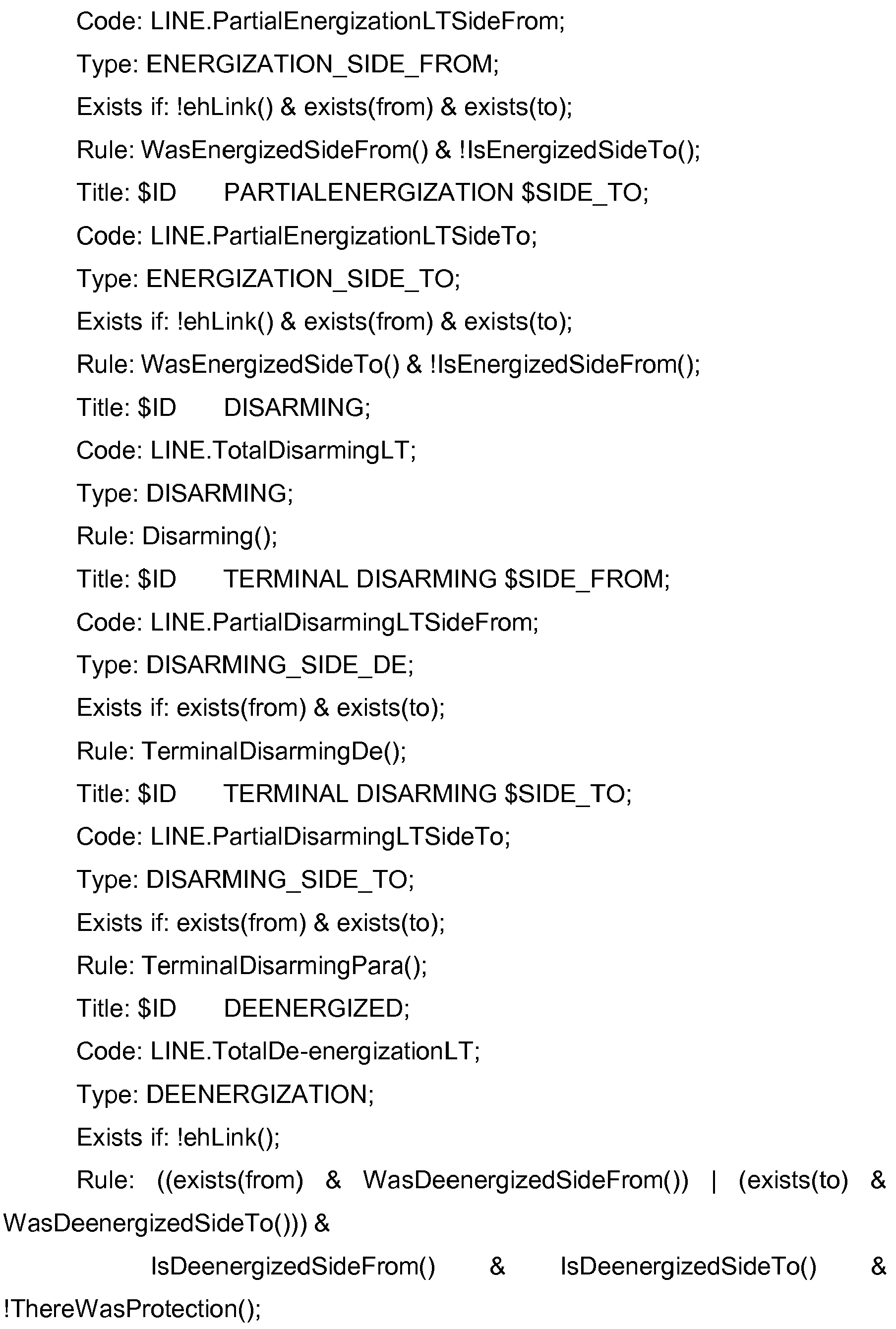

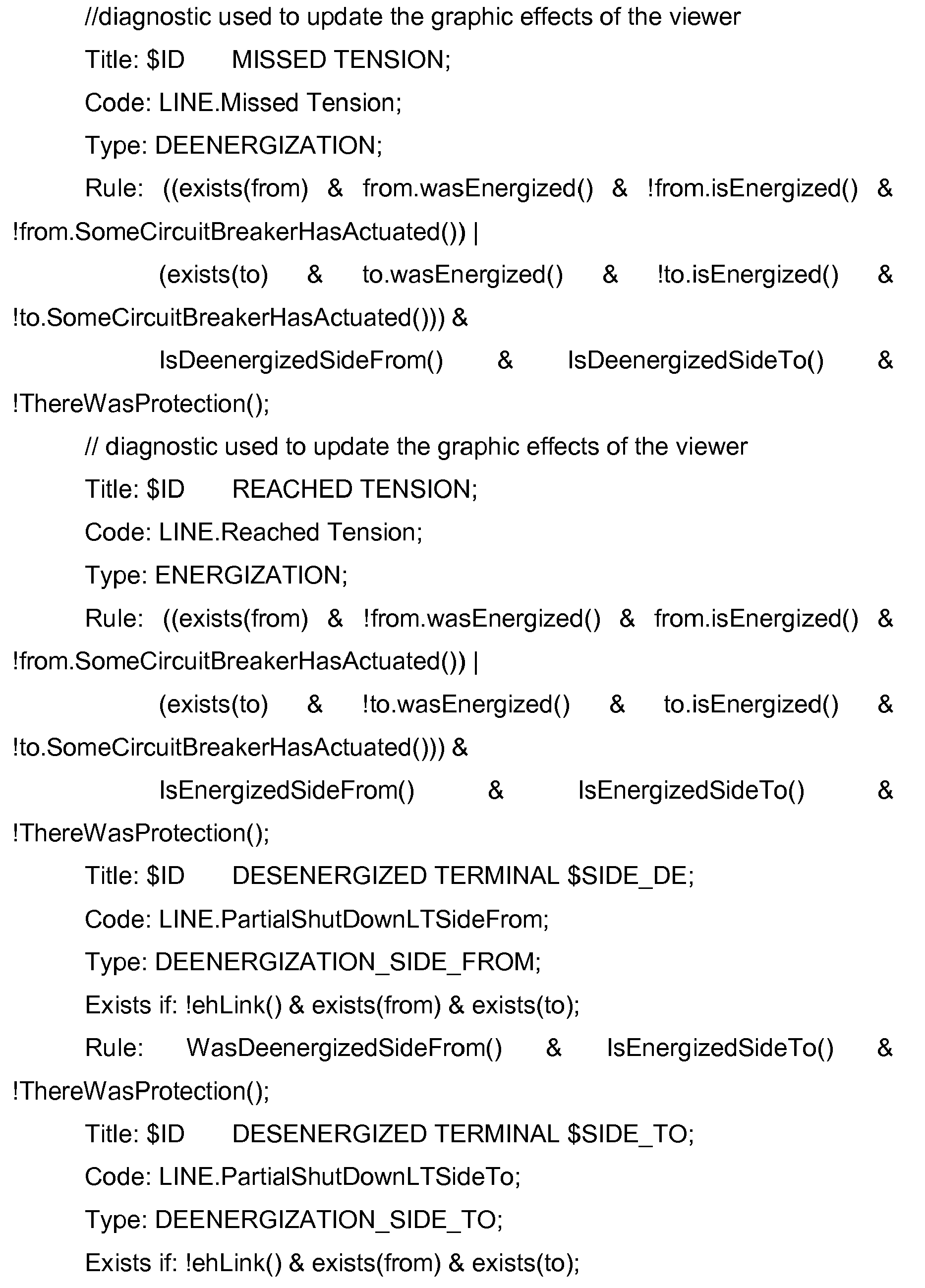

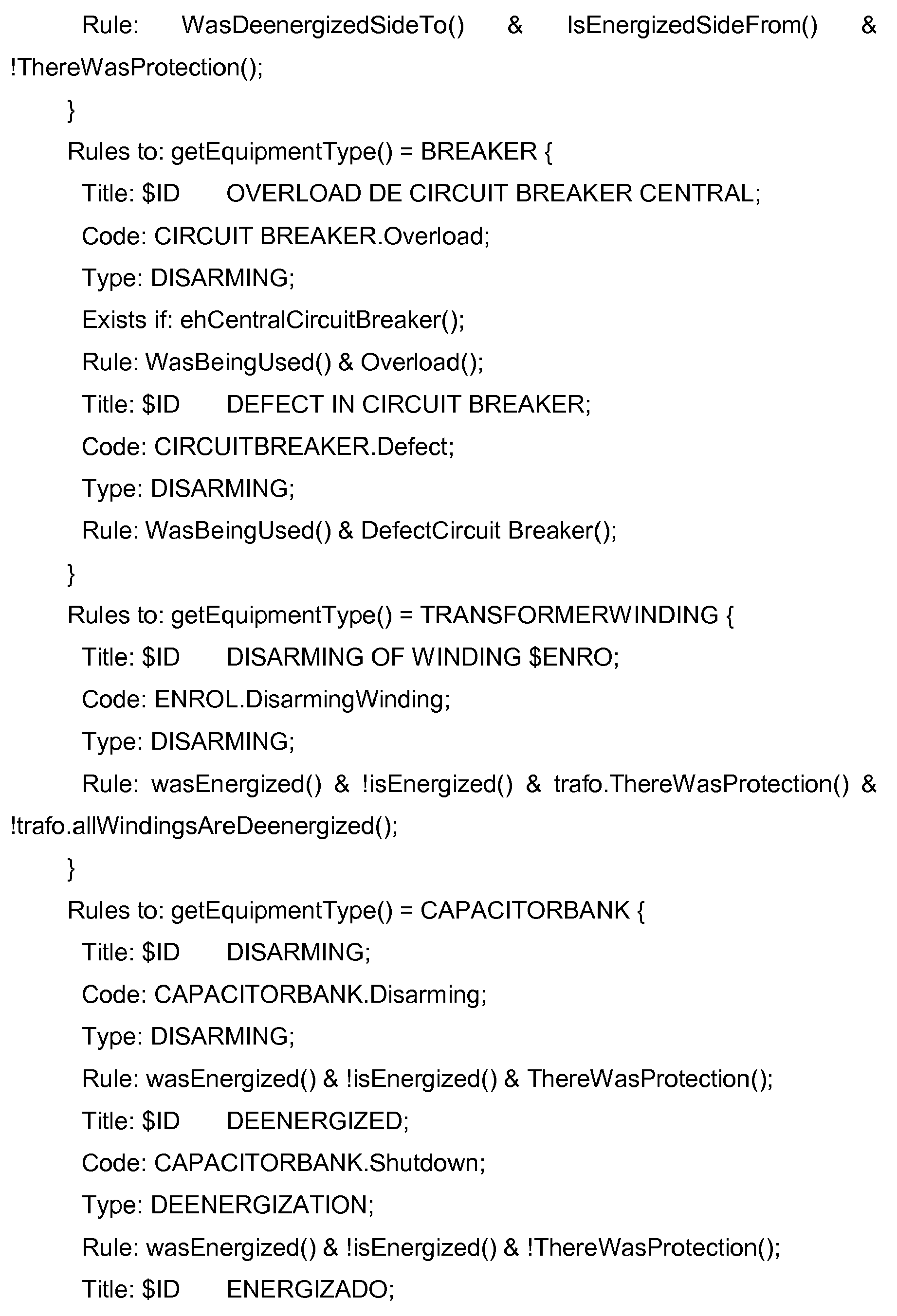

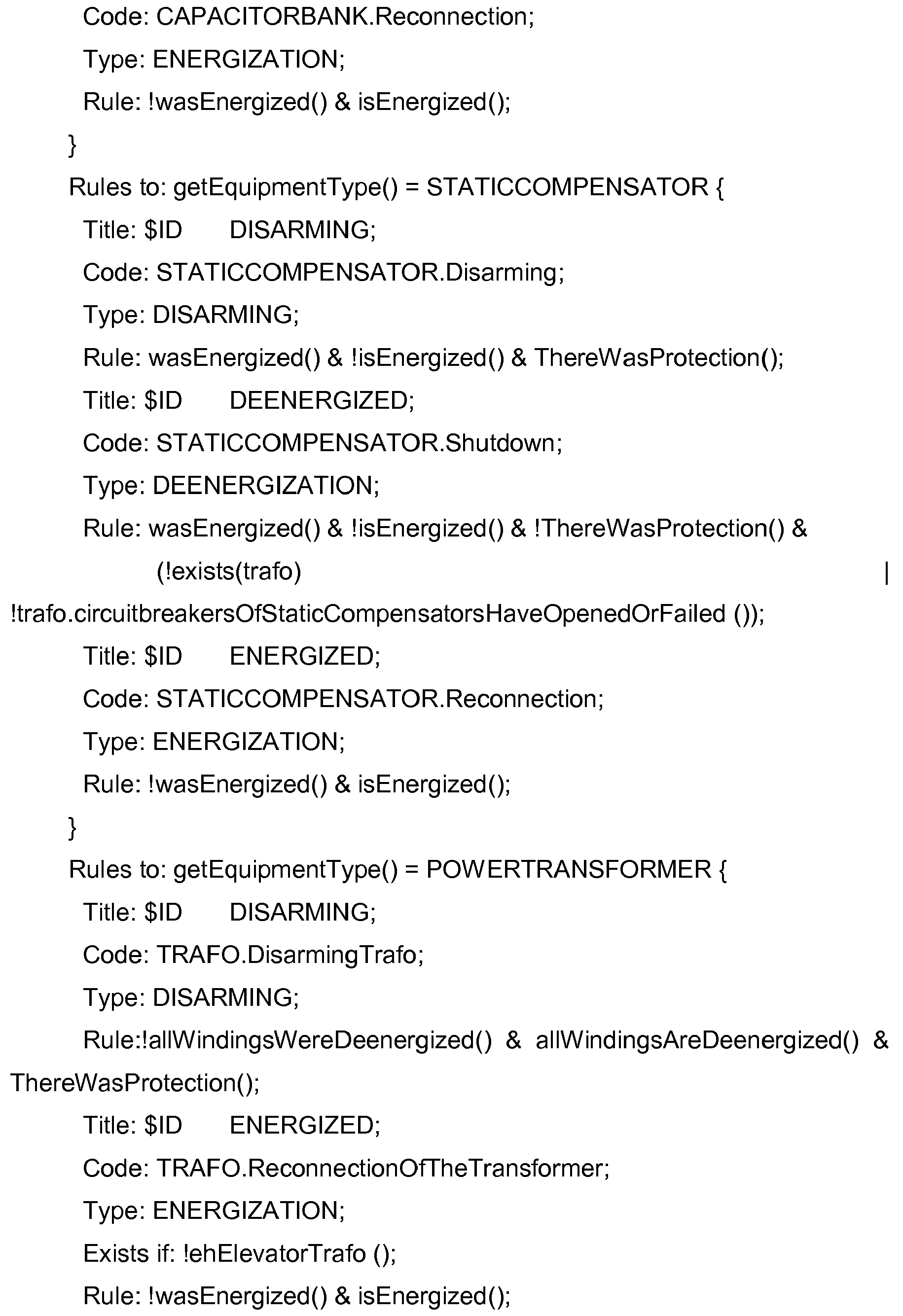

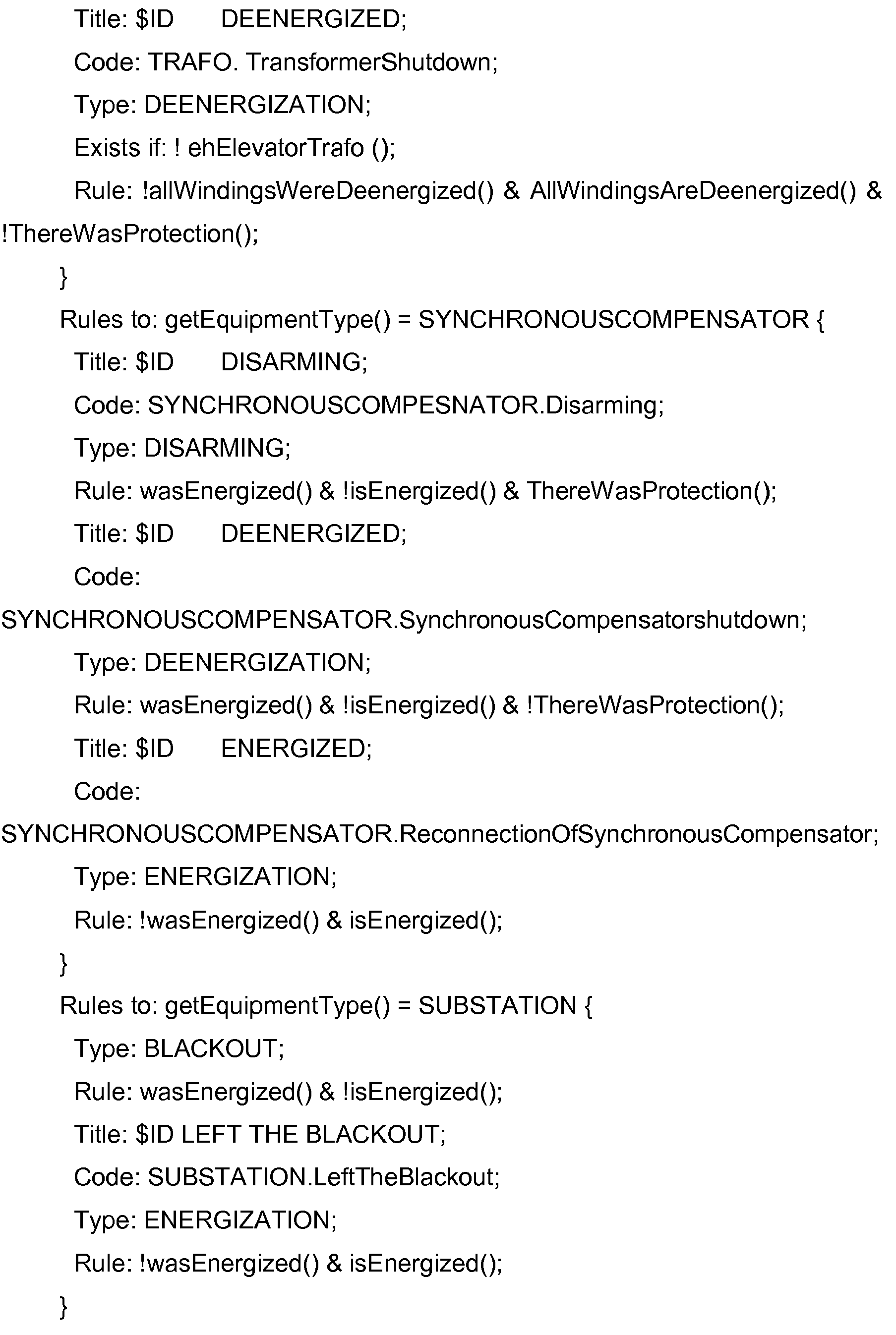

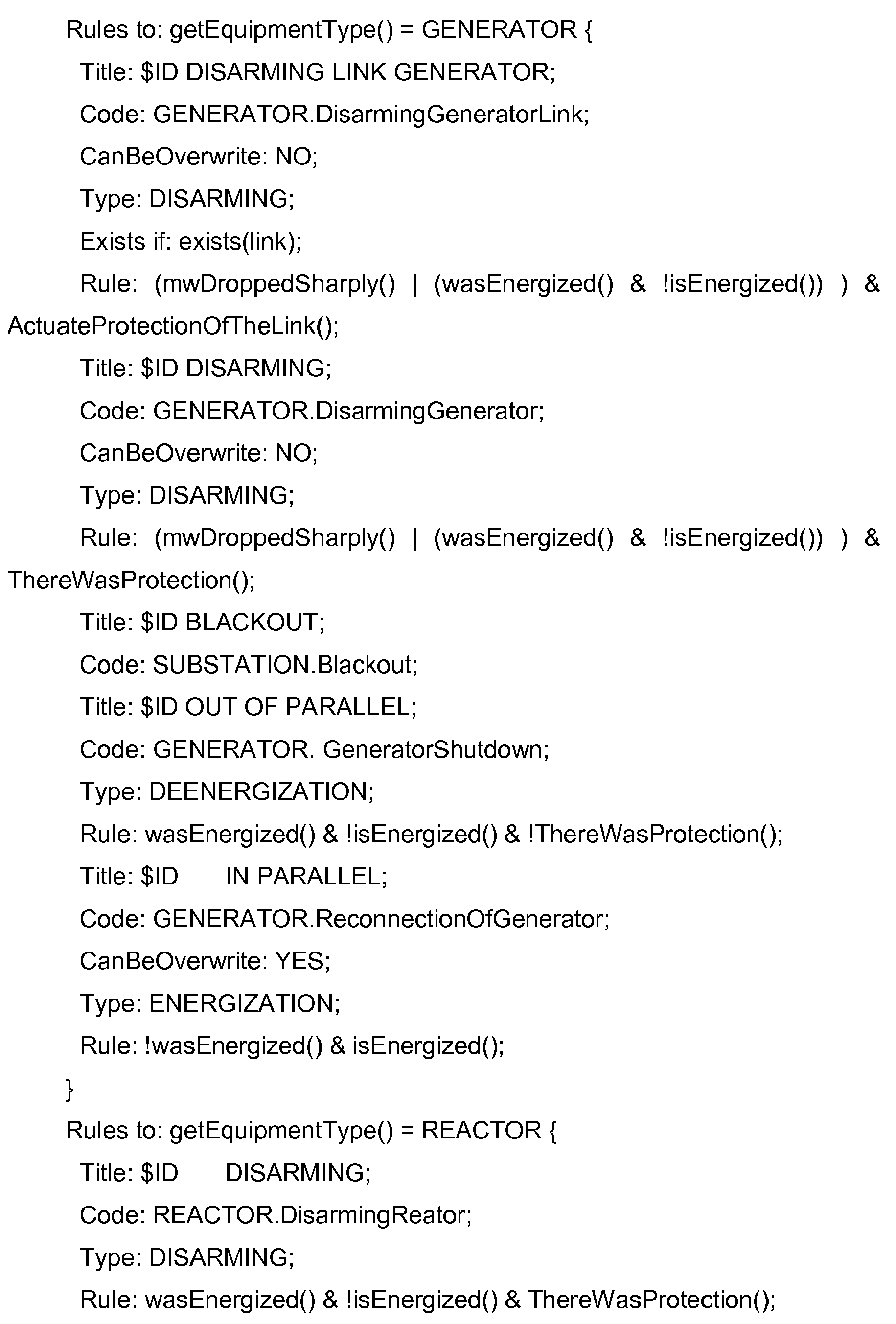

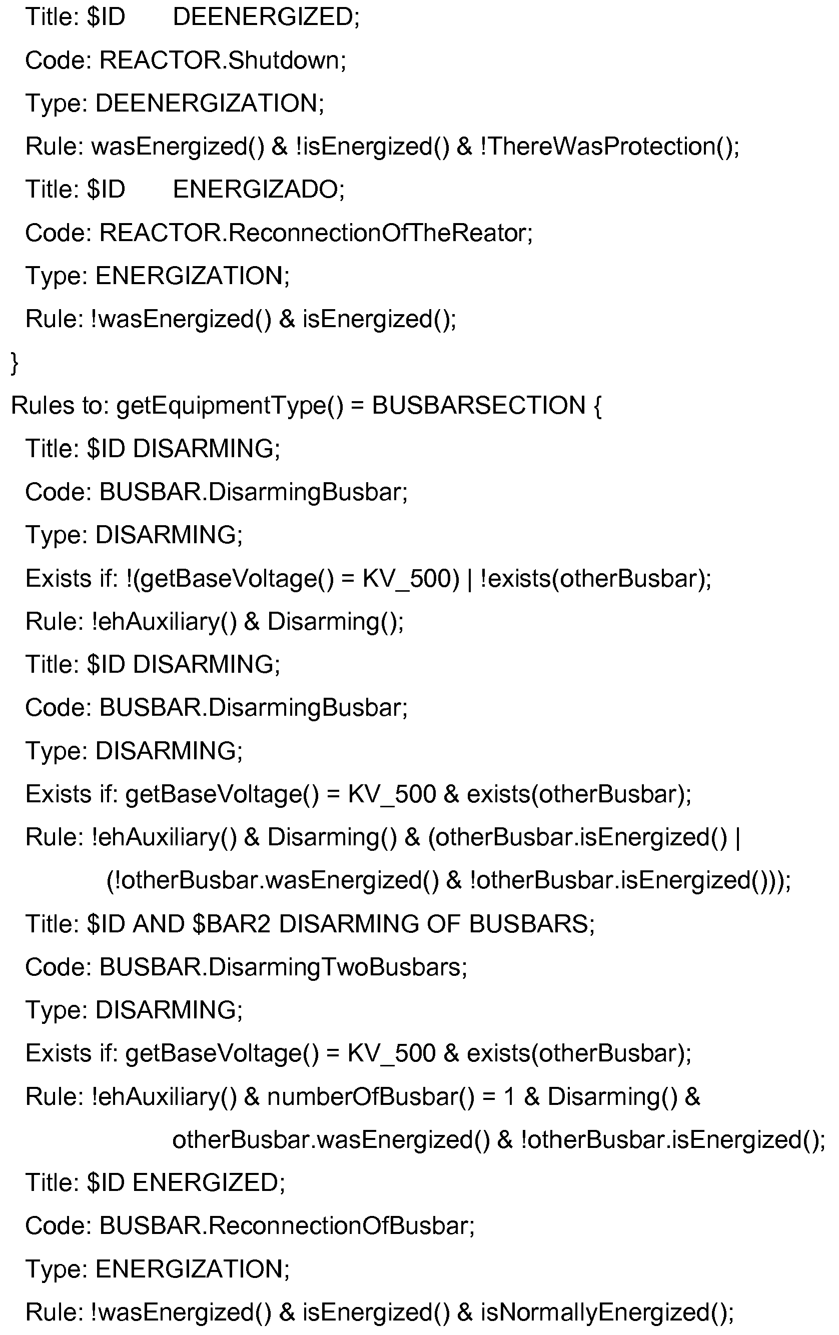

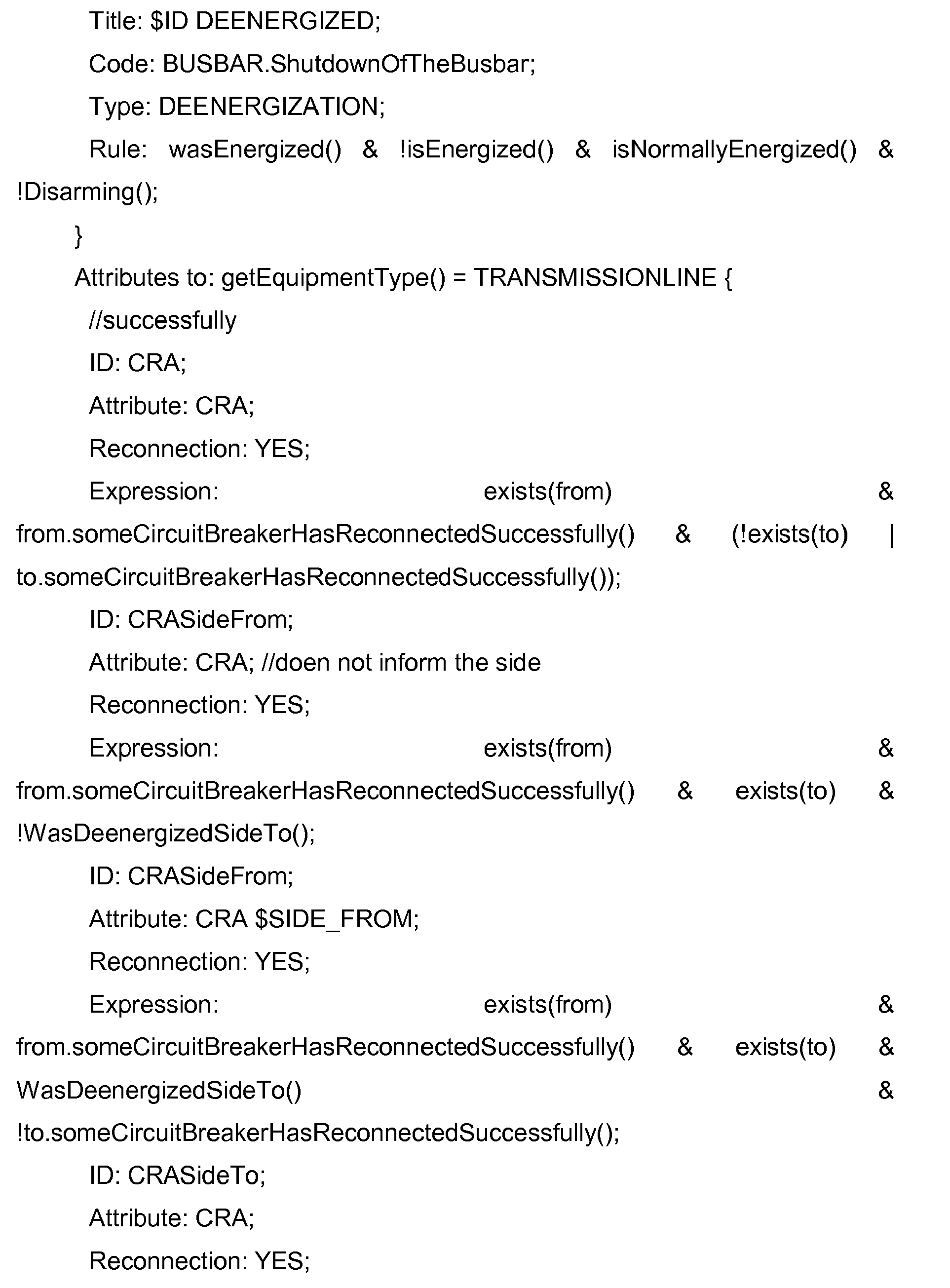

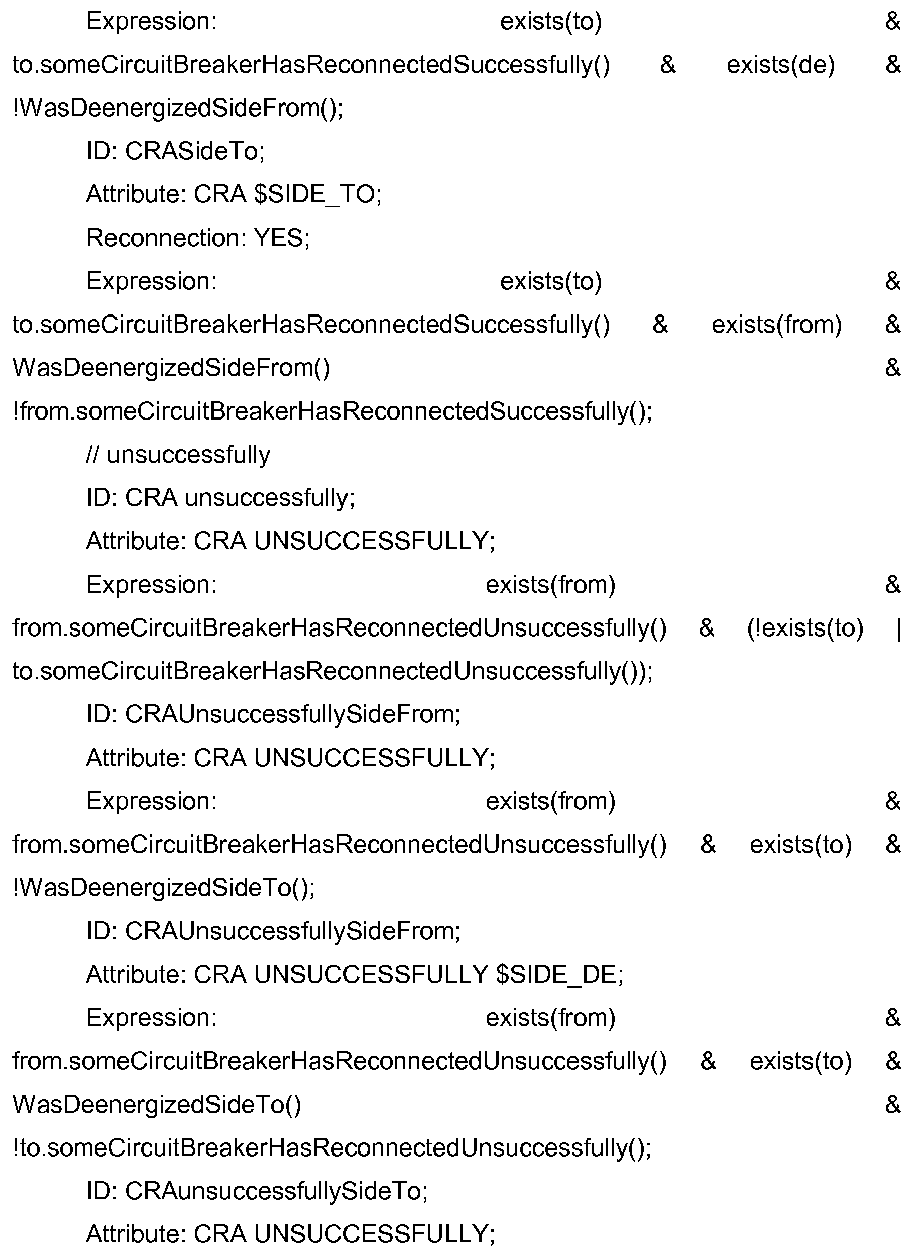

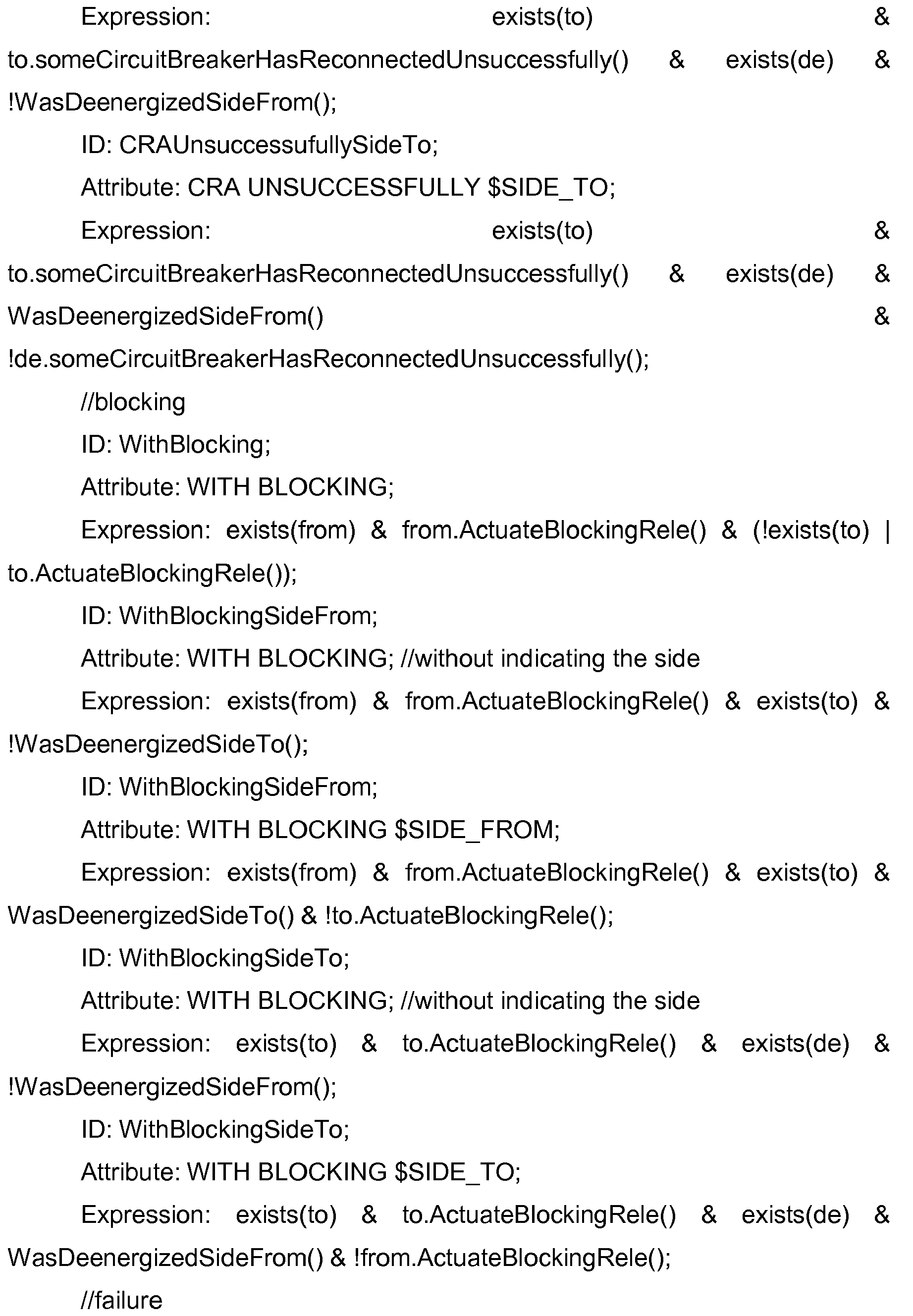

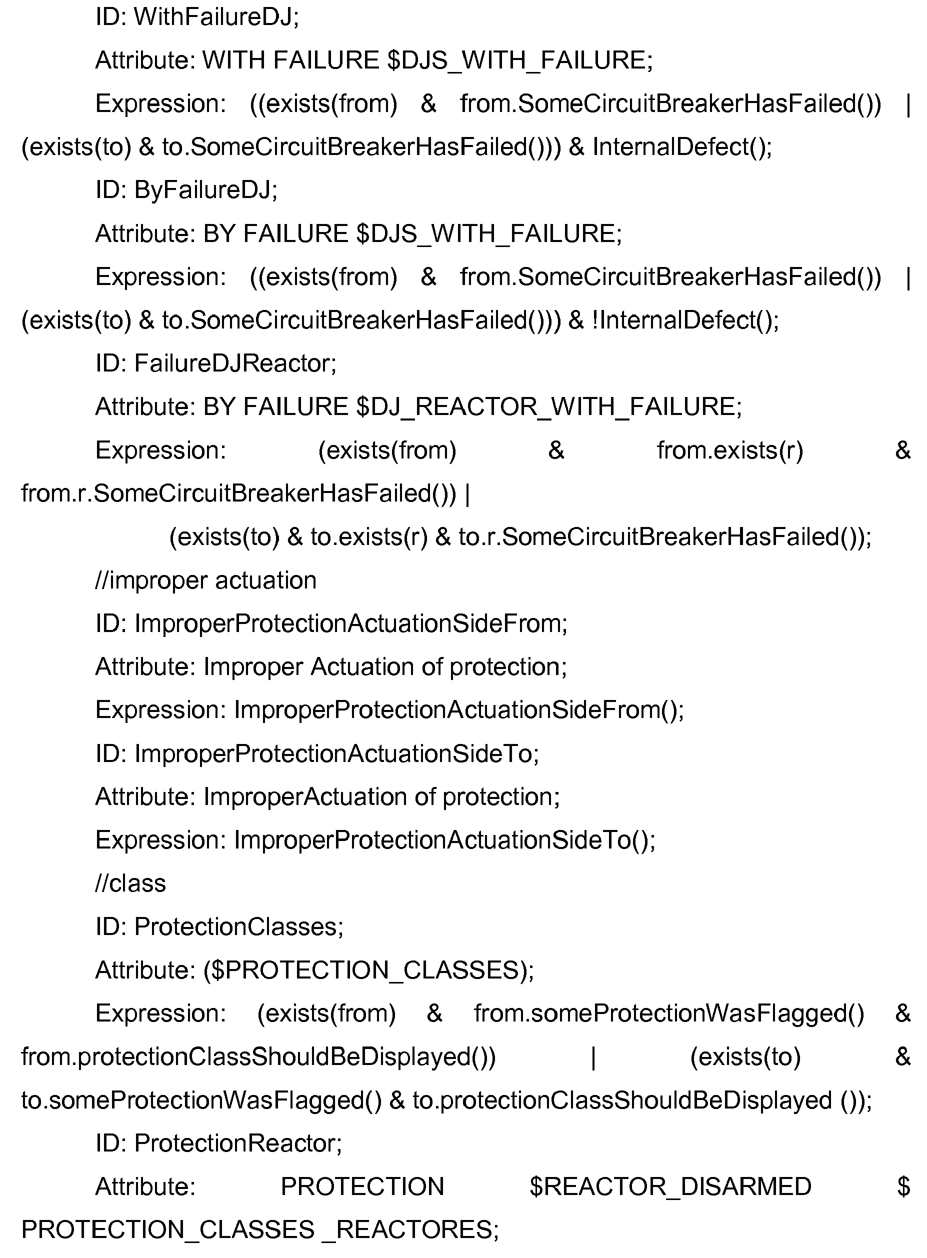

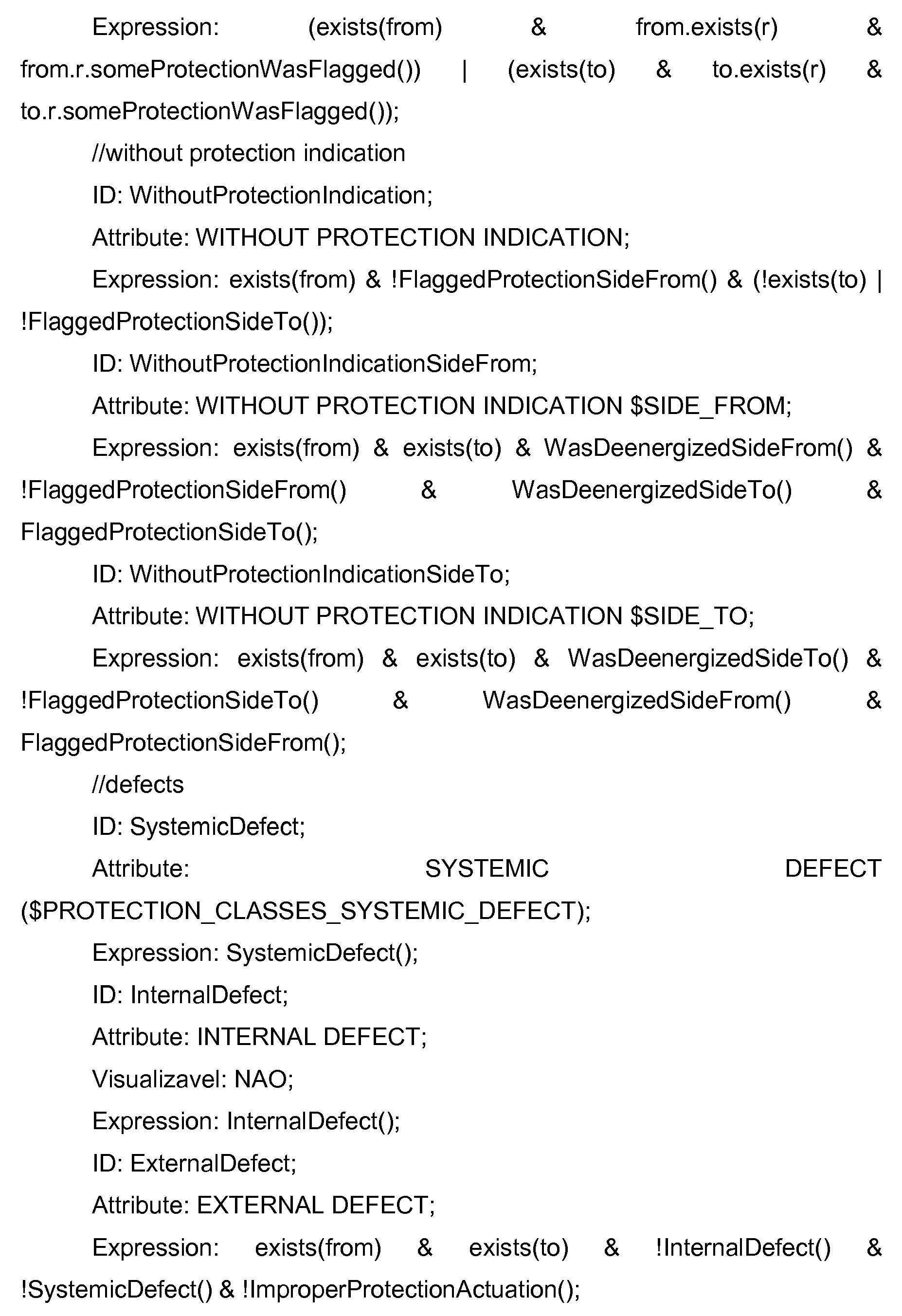

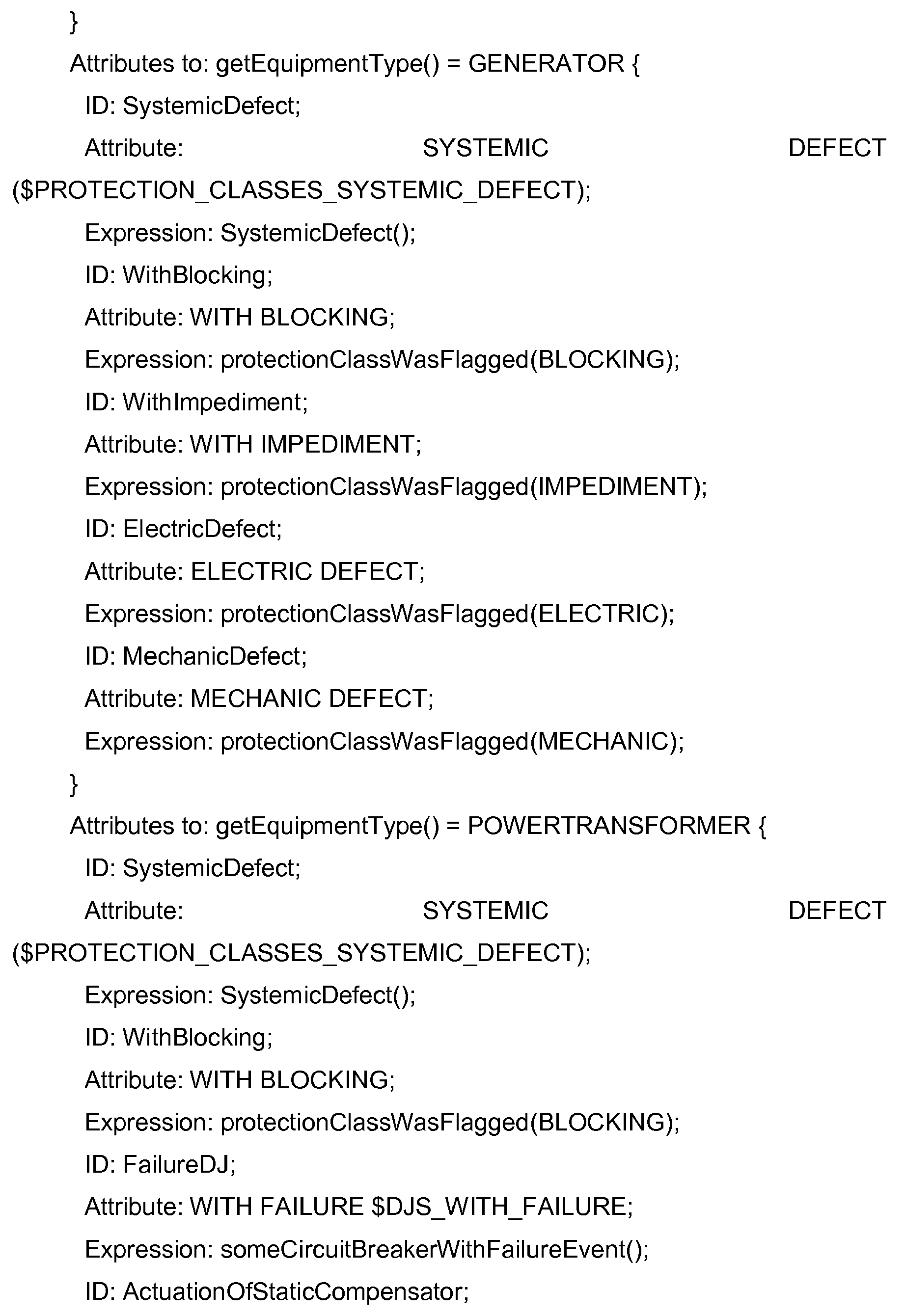

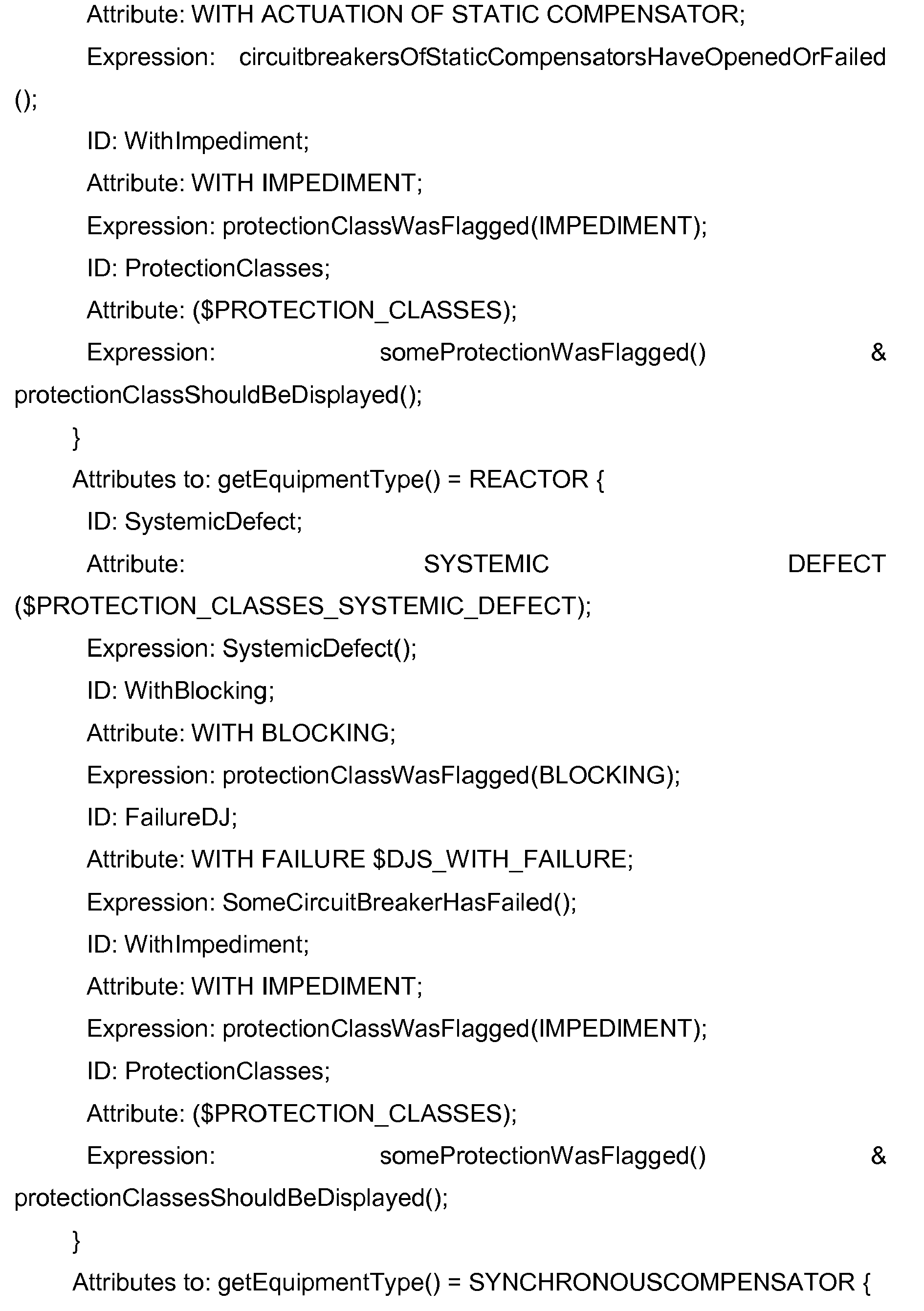

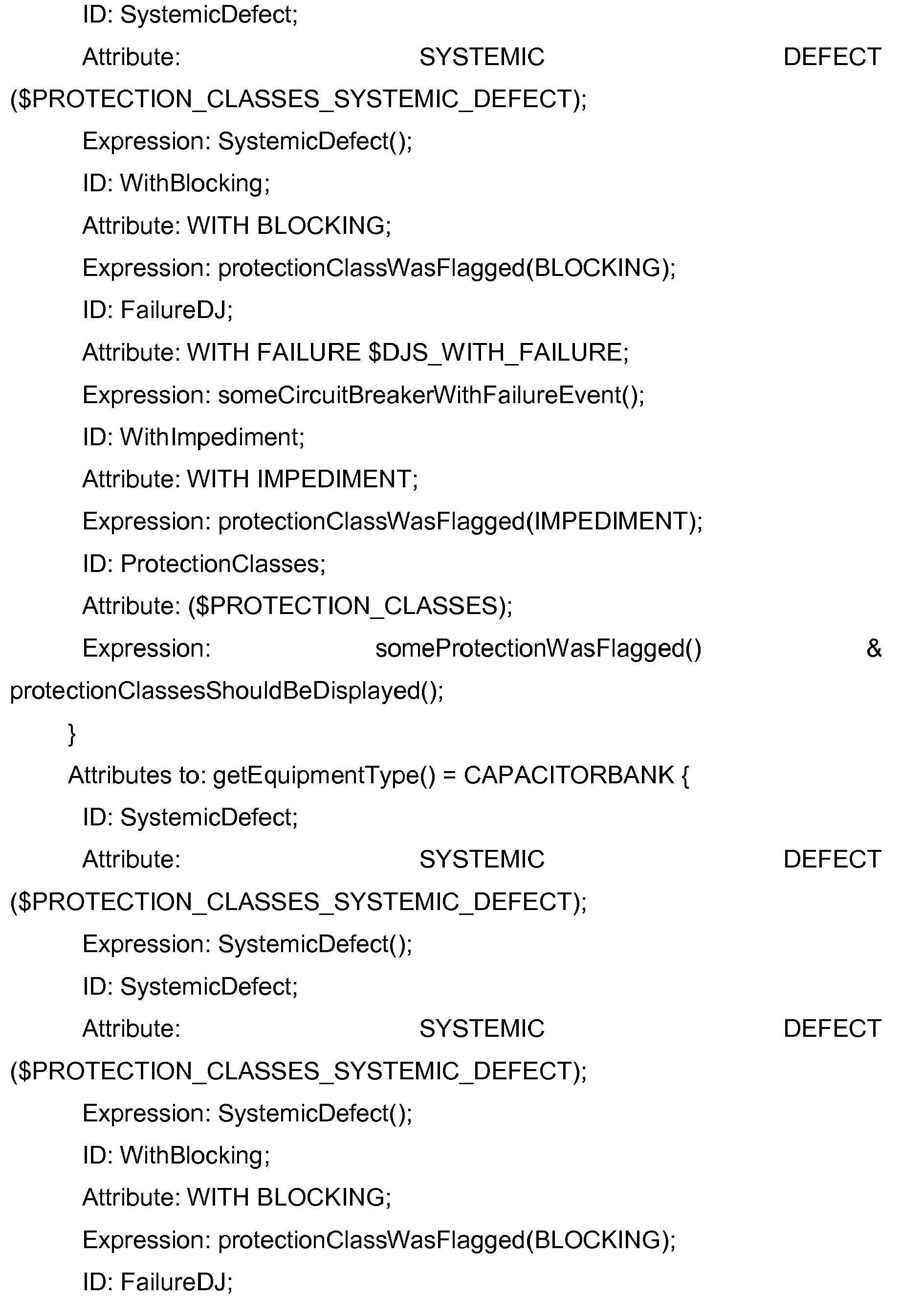

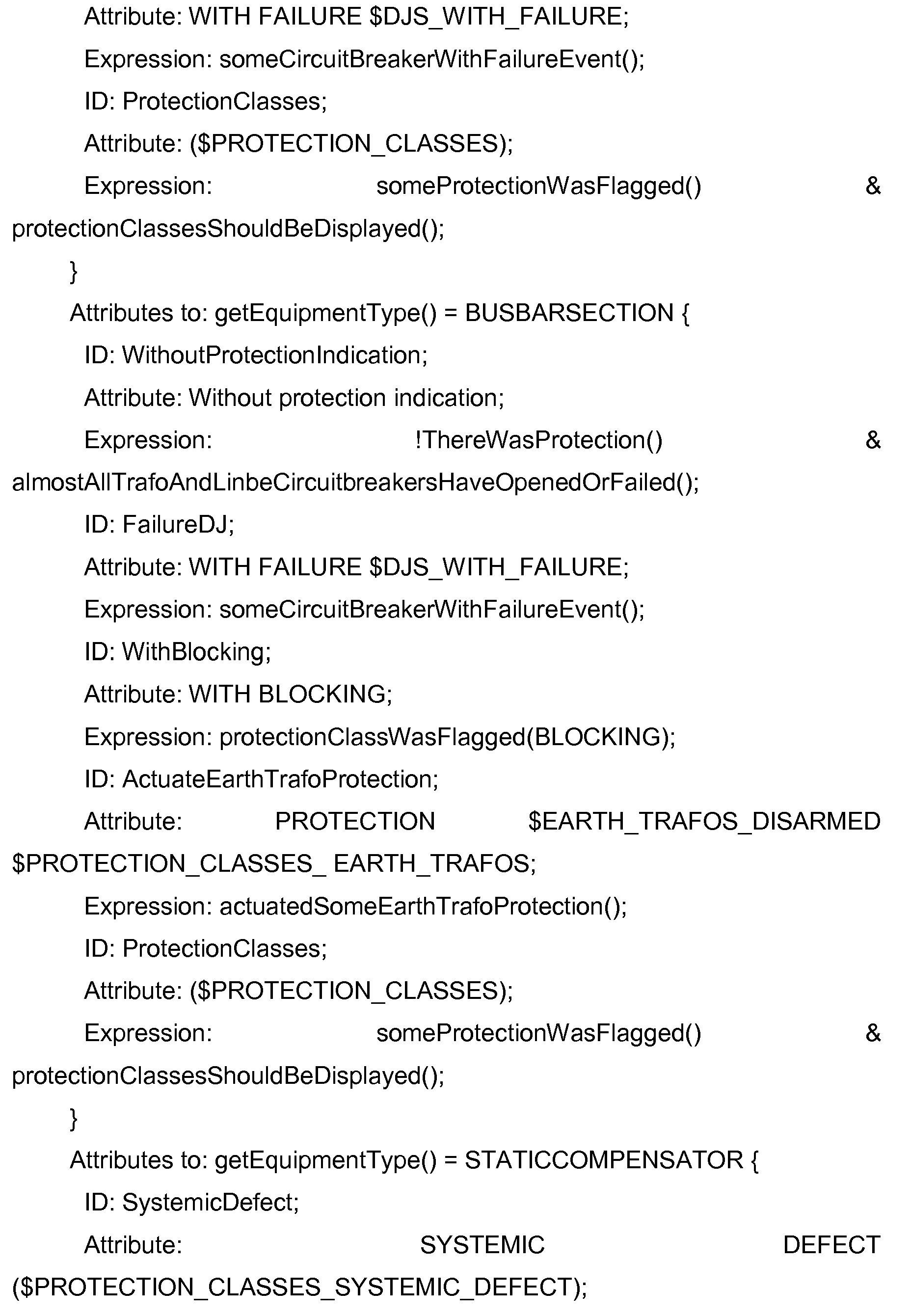

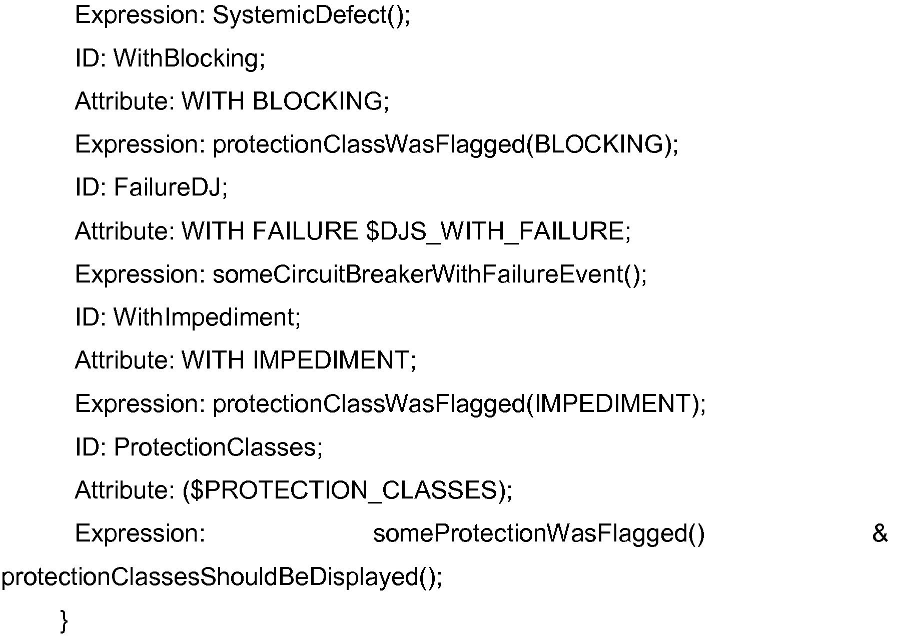

### Structure of an event

An event is composed by:
- Equipment: Equipment related to the event
- description: decription of the event
- nema: code of the protection associated to the event
- mnemonic: code of the event
- time of SCADA: time in which the event has closed in SCADA
- time of remote: time in which the event was generated in remote
- time of Smart Alarms: time in which the event has reached in Smart Alarms

### An example of an algorithm of the event processors and alarms emitter

```
Main algorithm {
 initializeThe DataStructures();
 loop() {
       updateEquipmentsEvents();
       updateConnectivityStateOfTheEquipments();
       generatesAlarms();
        }
       }
       initializeThe DataStructures (){
       readThe TopologyOf TheTopologyFile ();
 readThe RulesOfRulesFile();
 initializeMacros();
 initializeRules();
 initializeAttributes();
 }
 initializeMacros(){
       To each Equipment E of topology {
             To each <aGroupOfMacrosDefinitions> {
                    If a Booleanexpression of the group is true {
                           To each macro of the group {
                                  associates a macro to the equipment E
                                  
                    }
               }
          }
 }
}
initializeRules() {
 // how initializeMacros, but using aGroupOfRulesDefinitions
 }// and associating rules to the equipments
 initializeAttributes(){
 // how initializeMacros, but using aGroupOfAttributesDefinitions
 // and associating attributes to the equipments
 }
 updateEventsOfEquipments() {
 To each Equipment E of topology {
 Remove events in the equipment E which have expired
 }
 Recover events of the network
 To each recovered symptom {
       Add symptom in the equipment associated to the symptom
       
 }
}
 updateConnectivityStateOfTheEquipments() {
 To each equipment E in topology {
       E.wasConnected = E.isConnected
       E.isConnected = unknown
 }
 To each equipment E in topology {
       If E.isConnected = unknown
       Rotate algorithm DepthFirstSearch (DFS) searching a connected
       equipment
                    to this whose attribute isConnected = yes
       If it finds {
              E.isConnected = yes
             To each equipment equipWalked in the way of DFS {
                    equipWalked.isConnected = yes
             }
        }
 }
 To each equipment E in topology {
 If E.isConnected == unknown {
       E.isConnected = no
        }
 }
}
generateAlarmes(){
 To each equipment E in topology
       To each rule R associated to the equipment E
              If R.existenceCondition and R.ActivationCondition
                    Create Alarm A
                    To each attribute B in equipment E
                           If B. ActivationCondition {
                                  A.insert(B)
                           }
                    }
                    Replace the variables in the text of the alarm A
                    sendAlarm(A)
                    }
               }
         }
}
sendAlarm(A){
 To each alarm A generated
       If ((installation of the alarm A is NOT in BLACKOUT) OR (type of
       alarm A for DISARMING or BLACKOUT))
             SendToAlarmsViewer(A)
```

### Example 1 - Disarming of a transmission line by voltage overload

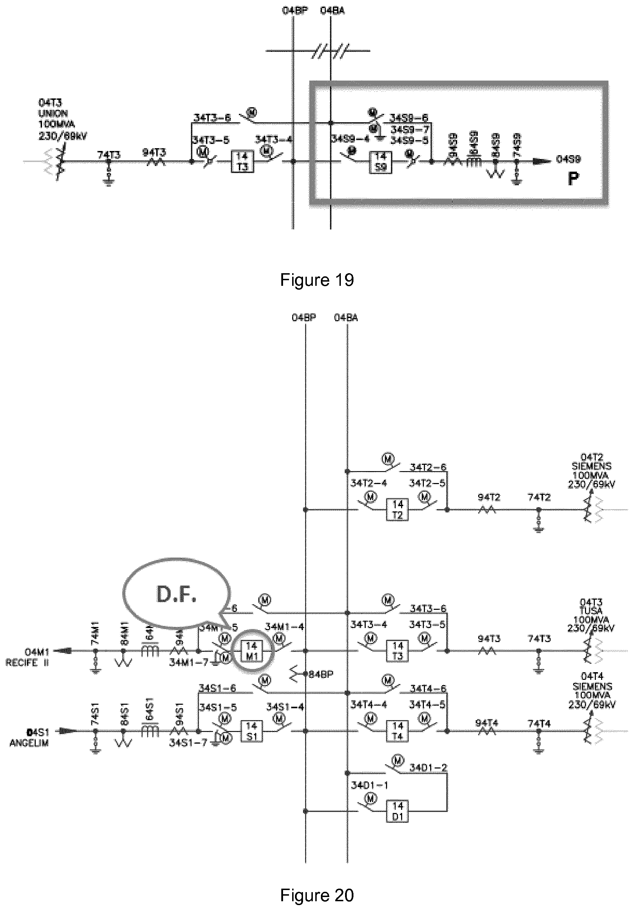

The scenario consists of a disarming of a transmission line by voltage overload The line 04S9 interconnecting the facilities of RL e P Will be used to illustrate the scenario. Figure 18 and figure 19 present two terminals of transmission line.

### Flagged Events:

- 14S9-PEN ABER
- 14S9-RLD ABER
- 04S9-PEN STTT
- 04S9-RLD STTT

### After updating of events

- 14S9-PEN ABER
- 14S9-RLD ABER
- 04S9-PEN STTT (event whose class of protection is overtension)
- 04S9-RLD STTT (event whose class of protection is overtension)

### After updating of connectivity state

- 04S9-PEN not connected to energized equipments
- 04S9-RLD not connected to energized equipments

### Alarms generation:

Equipments of the topology that will be evaluated whose existence and activation conditions Will be evaluated positively:
04S9-RLD/PEN
   Activated Rule: 'LINE.TotalDisarmingLT'
   Alarm partially generated: $ID DISARMING
   Attributes associated to equipment that will be evaluated positively:
      ID: ProtectionClasses;
Attribute: ($PROTECTION_CLASSES);
Partially generated alarm: $ID DISARMING ($PROTECTION_CLASSES)
Alarm generated after replacing the variables: 04S9-RLD/PEN DISARMING (OVERTENSION)

### Set of generated alarms:

04S9-RLD/PEN DISARMING (OVERTENSION)
Set of alarms send to the operator:
04S9-RLD/PEN DISARMING (OVERTENSION)

### Example 2 - Failure of circuit breaker in an installation of 230 kV

The scenario consists of a failure of circuit breaker in an installation of 230kV shown in figure 20. The circuit breaker 14M1 located in the installation of R will be used to illustrate the failure. As a result of the failure, all circuit breakers associated to the busbar of 230 kV of the installation will open, generating the blackout in the installation.

### Flagged Events:

- 14M1-RIB FLDI
- 04M1-RIB ATPR
- 04M1-RCD ATPR
- 04M 1-RCD ATRB
- 14M1-RCD ABER
- 14M1-RCD FECH
- 14M1-RCD ABER
- 14S1-RIB ABER
- 14T2-RIB ABER
- 14T3-RIB ABER
- 14T4-RIB ABER

### After updating of the events:

- 14M1-RIB failure of circuit breaker
- 04M1-RIB actuation of protection (class of protection: DISTANCE)
- 04M1-RCD actuation of protection (class of protection: DISTANCE)

### After updating of connectivity state

- 04M1-RCD Deenergized
- all equipments of Ribeirão were deenergized

### Alarms generation:

Equipments of topology that will be evaluated whose existence and activation condition will be evaluated positively:
04M1-RCD/RIB
Activated Rule: 'LINE.TotalDisarmingLT'
Partially generated alarm: $ID DISARMING

Attributes associated to the equipment that will be evaluated positively:
ID: CRAUnsuccessfullySideFrom;
Attribute: CRA UNSUCCESSFULLY $SIDE_FROM;
ID: WithFailureDJ;
Attribute: WITH FAILURE $DJS_WITH_FAILURE;
ID: ProtectionClasses;
Attribute: ($PROTECTION_CLASSES);
Partially generated alarm: $ID DISARMING CRA UNSUCCESSFULLY $SIDE_FROM WITH FAILURE $DJS_WITH_FAILURE ($PROTECTION_CLASSES)
Alarm generated after replacing the variables: 04M1-RCD/RIB DISARMING CRA UNSUCCESSFULLY RCD WITH FAILURE 14M1-RIB (DISTANCE)
RIB
   Activated Rule: 'SUBSTATION.Blackout'
   Partially generated alarm: $ID BLACKOUT
   There are not attributes to the type of equipment 'SUBSTATION'
   Alarm generated after replacing the variables: RIB BLACKOUT 04S1-AGL/RIB
   Activated Rule: 'LINE.PartialShutDownLTSideTo'
   Partially generated alarm: $ID DESENERGIZED TERMINAL $SIDE_TO
   No attribute associated to transformer was positively evaluated.
Alarm generated after replacing the variables: 04S1-AGL/RIB DEENERGIZED TERMINAL RIB
04T2-RIB, 04T3-RIB, 04T4-RIB

To each equipment:
Activated Rule: 'TRAFO.ShutdownOfTheTransformer'
   Partially generated alarm: $ID DEENERGIZED
No attribute associated to transformer was positively evaluated.

Alarm generated after replacing the variables:
04T2-RIB DEENERGIZED
04T3-RIB DEENERGIZED
04T4-RIB DEENERGIZED
04BP-RIB, 02BP-RIB

To each equipment:
Activated Rule: 'BUSBAR.ShutdownOfBusbar'
   Partially generated alarm: $ID DEENERGIZED
No attribute associated to transformer was positively evaluated.

Alarm generated after replacing the variables:
04BP-RIB DEENERGIZED
02BP-RIB DEENERGIZED
02L1-RIB, 02L2-RIB, 02L3-RIB, 02L4-RIB, 02L5-RIB, 02L6-RIB, 02L7-RIB, 02L8-RIB, 02L9-RIB

To each equipment:
Activated Rule: 'LINE.MissedTension
   Partially generated alarm: $ID MISSED TENSION
No attribute associated to transformer was positively evaluated.

Alarm generated after replacing the variables:
02L1-RIB MISSED TENSION
02L2-RIB MISSED TENSION
02L3-RIB MISSED TENSION
02L4-RIB MISSED TENSION
02L5-RIB MISSED TENSION
02L6-RIB MISSED TENSION
02L7-RIB MISSED TENSION
02L8-RIB MISSED TENSION
02L9-RIB MISSED TENSION
Set of generated alarms:
RIB BLACKOUT
04M1-RCD/RIB DISARMING CRA UNSUCCESSFULY RCD WITH FAILURE 14M1-RIB (DISTANCE)
04S1-AGL/RIB DESENERGIZED TERMINAL RIB
04T2-RIB DEENERGIZED
04T3-RIB DEENERGIZED
04T4-RIB DEENERGIZED
04BP-RIB DEENERGIZED
02BP-RIB DEENERGIZED
02L1-RIB MISSED TENSION
02L2-RIB MISSED TENSION
02L3-RIB MISSED TENSION
02L4-RIB MISSED TENSION
02L5-RIB MISSED TENSION
02L6-RIB MISSED TENSION
02L7-RIB MISSED TENSION
02L8-RIB MISSED TENSION
02L9-RIB MISSED TENSION

### Set of alarms sent to the operator:

04M1-RCD/RIB DISARMING CRA UNSUCCESSFULY RCD WITH FAILURE 14M1-RIB (DISTANCE)
RIB BLACKOUT

### Example 3 - Scenarios in an electrical grid

### Scenario 1

In the first step (Relations of topology/flow) it is possible to identify that the alarms lines from 1 to 7 depend on the transformers of alarms 8 and 9, and that the lines are equal to one another in relation to the flow, and the transformers as well. To this scenario, the graph which represents the energy flow between the elements is figure 7.

Suppose the filter stage needs to separate the alarms by diagnostic and by type de element, the resulting graph is the same because 8 and 9 have the same diagnostic e both are transformers, the same way 1, 2, 3, 4, 5, 6 e 7 gave the same diagnostic and all of them are lines.

To the validation of relation in the graph, the following propagation rule is used::
- To the relation Transformer → Line:
   ∘ If Transformer = '*disarming with actuation of protection of phase overcurrent* then Line = '*Deenergized*'.

With this rule (or some similar) it is possible to validate the model connection, now being the final model, where the alarms 8 e 9 are root causes, and the others its consequences.

### Scenario 2

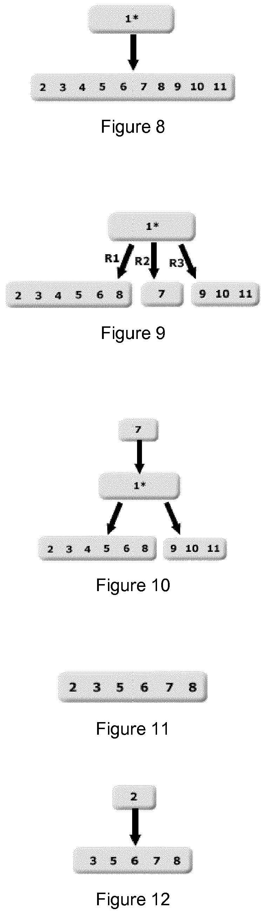

In the first step it is possible to identify that all components depend on the alarm bars 1*, and that they are equal to one another in relation to the flow. To this scenario, the graph represents the energy flow between the alarms by diagnostic e by type of element, the resulting graph is the one of figure 9. Where, 2, 3, 4, 5, 6 e 8 have the same diagnostic and are lines, da same way 9, 10 e 11 have the same diagnostic e all of them are transformers, and 7 is a line with the different diagnostic from the others; R1, R2 e R3 are the relations between the graph elements.

To the validation of the graph relations, the following propagation rules are used:
- To a relation Bar → Line:
   ∘ Rule 1: If Bar = '*disarming by overtension*/*failure of circuit breaker*' then Line = '*Deenergized*'.
   ∘ Rule 2: If Line = *'disarming'* then Bar = *'disarming by overtension*/*failure of circuit breaker*'.
- To a relation Bar → Transformer:
   ∘ Rule 3: If Bar = '*disarming by overtension*/*failure of circuit breaker*' then Transformer = '*disarming by overtension*'.

The rule 1 confirms the relation R1 of the graph; the rule 2 modifies the relation R2 of the graph, changing the relation direction, thus indicating that the alarm 7 occurred first.; the rule 3 confirms the relation R3 of the graph, thus maintaining the connection. The resulting graph is of Figure 10, where the alarm 7 is considered the root cause of the others. It is possible, for example, that the rule 3 gets into conflict with some other, or it does not exist, in this case, it should be tried to use the connection validation.

### Scenario 3

In the first step it is possible to identify that the lines of the alarms 2, 3, 5, 6, 7 e 8 are equal to one another in relation to the flow. To this scenario, the graph that represents the energy flow between the elements is of Figure 11. The alarm 1 is not present in the model and, in fact, it is considered a noise in the occurrence. Supposing that the filter step needs to separate the alarms by diagnostic and by type of element; the resulting graph is the same as all the elements are lines and have the same diagnostic.

In the model there are no relations, in this case, the chronology was used to define which alarm occurred first. The alarm 2 occurred first, then the resulting model is the Figure 12. The model indicates the alarm 2 as the root cause, and the others as consequences.

### Example 4 - Smart Alarm

Na embodiment of the system and method of the present invention was the development called "Smart Alarm". It was carried out applying phase practice called experimental operation pre-phase, with the main objective of obtaining a significant contribution of system operators in developing technical specifications and interfaces to the user. In the operating phase, the monitoring was performed to confirm proper functioning of the system of the invention. The Smart Alarm behaved satisfactorily, and in real situations of occurrences in the electrical system, introduced quickly the diagnostic without compromising the performance of the supervisory system, with the strength between system operators presenting the graphic diagnostic.

The importance of the Smart Alarm for the decision-making process can be well seen in one case occurred in electrical grid of the subsystem that caused disarming of all transmission lines 230KV associated to Bar of 230KV in the substation and subsequent shutdown of the Bar of 69KV and of all its respective feeders in total generated over 5,000 alarms and events that were presented to the operators of the system by the supervisory control system. The Smart Alarm, due to "generic rules", summarized the occurrence in only 18 diagnostics of the disarming of transmission lines and shutdown of transformers and one root cause (Defect in the Bar 230KV of the substation).

Through this example, we see the importance of this tool, to the operation in real time. The speed and power of synthesis inserted in the process of real-time operation via the Smart Alarm is a very important gain, especially with the advent of variable portion where it can reduce the downtime of the transmission function.

Those skilled in the art will value the knowledge presented herein and may reproduce the invention in presented modalities and in others variants covered in the scope of the appended claims.

## Claims

1. Method for real-time and automatic diagnostics in electrical grids, comprising the following steps:
i. checking if the equipment is connected/energized or not connected;
ii. checking if the equipment was connected/energized or not connected;
iii. modeling the connections between equipments of the electrical grid;
the method being **characterized by**:
iv. creation of topological parameters for inserting generic rules to the equipment type and/or type/ types of equipment;
v. generating diagnostics through said generic rules;
vi. updating the state of topology comprising:
- removing diagnostic/diagnostics with expired symptom /symptoms ;
- recovering diagnostics with network's symptoms; and
- adding symptoms in the associated equipment;
wherein said generic rules being applied on equipment classes, translating if the transmission line is connected or not to some energized equipment and comprise rule/rules and/or macro/macros and/ or attribute/attributes.

2. Method according to claim 1, **characterized by** an equipment comprise a plurality of associated equipments and, in turn, an associated equipment comprise a plurality of associated equipments.

3. Method according to one of the claims 1 to 2, **characterized by** additionally uses the Topological Primitives Logic to inform the current topology in the network on diagnostics generation.

4. System for real-time and automatic diagnostics in electrical grids comprising:
i. means for generating the topology;
ii. means for checking if the equipment is connected/energized or not connected;
iii. means for checking if the equipment was connected/energized or not connected;
iv. means for interconnecting networks and for modeling the connection between equipments of the electrical grid;
v. means for maintaining a representation of the topology of electrical grid, wherein the system further comprises:
vi. means for creation of topological parameters for inserting generic rules to the equipment type and/or type/types of equipment and
vii. means for updating the state of the topology, said means for updating comprising:
- removing diagnostic/diagnostics with expired symptom/symptoms;
- recovering diagnostics with network's symptoms; and
- adding symptoms in the associated equipment;
viii. means for generating diagnostics by generic rules based on collect information; and optionally,
ix. means for generating the diagnostics screens,
wherein said generic rules being applied on equipment classes, translating if the transmission line is connected or not to some energized equipment and comprise rule/rules and/or macro/ macros and/or attribute/attributes.

## Patentansprüche

1. Verfahren zur Echtzeit- und automatischen Diagnostik in elektrischen Netzen, das die folgenden Schritte umfasst:
i. Kontrollieren, ob die Ausrüstung angeschlossen/aktiviert oder nicht angeschlossen ist;
ii. Kontrollieren, ob die Ausrüstung angeschlossen/aktiviert oder nicht angeschlossen war;
iii. Modellieren der Verbindungen zwischen Anlagen des elektrischen Netzes;
wobei das Verfahren **gekennzeichnet ist durch**:
iv. Erzeugung von topologischen Parametern zum Einführen von allgemeinen Normen in den Anlagentyp und/oder Typ/Typen von Ausrüstung;
v. Erzeugen von Diagnoseverfahren **durch** die allgemeinen Normen;
vi. Aktualisieren des Status der Topologie, umfassend:
- Entfernen der Diagnoseprogrammen/-verfahren bei nicht mehr gültigen Symptomen/Symptomen;
- Wiederherstellen der Diagnoseprogramme bei Symptomen des Netzes; und
- Hinzufügen von Symptomen in der zugehörigen Ausrüstung;
wobei die allgemeinen Normen auf Ausrüstungsklassen angewendet werden, was klärt, ob die Übertragungsleitung an einige aktivierte Anlagen angeschlossen ist oder nicht, und umfasst Regel/Regeln und/oder Makro/Makros und/oder Attribut/Attribute.

2. Verfahren nach Anspruch 1, **gekennzeichnet durch** eine Ausrüstung, die eine Vielzahl von zugehörigen Anlagen umfasst und, andererseits, eine verbundene Anlage umfasst eine Vielzahl von zugehörigen Anlagen.

3. Verfahren nach einem der Ansprüche 1 bis 2, **gekennzeichnet durch** die zusätzlichen Verwendungen der Typologischen Grundelemente-Logik zum Informieren der aktuellen Topologie im Netz über die Diagnostikprogramm-Erzeugung.

4. System zur Echtzeit- und automatischen Diagnostik in elektrischen Netzen, umfassend:
i. Mittel zum Erzeugen der Topologie;
ii. Mittel zum Kontrollieren, ob die Ausrüstung angeschlossen/aktiviert oder nicht angeschlossen ist;
iii. Mittel zum Kontrollieren, ob die Ausrüstung angeschlossen/aktiviert oder nicht angeschlossen war;
iv. Mittel zum Verbinden von Netzen und zum Modellieren der Verbindung zwischen Anlagen des elektrischen Netzes, **gekennzeichnet durch**:
v. Mittel zum Aufrechterhalten einer Darstellung der Topologie des elektrischen Netzes, wobei das System ferner umfasst:
vi. Mittel zum Erzeugen von topologischen Parametern zum Einführen von allgemeinen Normen in den Ausrüstungstyp und/oder Typ/Typen von Ausrüstung, und
vii. Mittel zum Aktualisieren des Status der Topologie, wobei die Mittel zum Aktualisieren umfassen:
- Entfernen von Diagnoseprogramm/-programmen bei nicht mehr gültigem Symptom/Symptomen;
- Wiederherstellen der Diagnoseprogramme bei Symptomen des Netzes; und
- Hinzufügen von Symptomen in der zugehörigen Ausrüstung;
viii.Mittel zum Erzeugen von Diagnoseprogrammen durch allgemeine Normen auf der Basis von gesammelten Informationen; und optional
ix. Mittel zum Erzeugen der Diagnosebildschirme, wobei die allgemeinen Normen angewendet werden auf Ausrüstungsklassen, was klärt, ob die Übertragungsleitung an einige aktivierte Anlagen angeschlossen ist oder nicht, und umfasst Regel/Regeln und/oder Makro/Makros und/oder Attribut/Attribute.

## Revendications

1. Procédé de diagnostic en temps réel et automatique dans des réseaux électriques, comprenant les étapes suivantes :
i. vérification si l'équipement est connecté/énergisé ou non connecté ;
ii. vérification si l'équipement a été connecté/énergisé ou non connecté ;
iii. modélisation des connexions entre les équipements du réseau électrique ;
ce procédé étant **caractérisé par** :
iv. la création de paramètres topologiques pour insérer des règles génériques dans le type d'équipement et/ou le type/les types d'équipements ;
v. la génération de diagnostics par l'intermédiaires desdites règles génériques ;
vi. l'actualisation de l'état de la topologie comprenant :
- la suppression d'un diagnostic/de diagnostics dont le symptôme/les symptômes ont expiré ;
- la récupération de diagnostics présentant des symptômes du réseau ; et
- l'adjonction de symptômes dans l'équipement associé ;
lesdites règles génériques étant appliquées sur les classes d'équipement, la translation si la ligne de transmission est connectée ou non à certains équipements énergisés, et comprenant une règle/des règles et/ou une macro/des macros et/ou un attribut/des attributs.

2. Procédé selon la revendication 1, **caractérisé en ce qu'**un équipement comprend une pluralité d'équipements associés et que, à son tour, un équipement associé comprend une pluralité d'équipements associés.

3. Procédé selon l'une quelconque des revendications 1 à 2, **caractérisé par** des utilisations additionnelles de la logique primitive topologique pour informer la topologie en cours dans le réseau sur la génération de diagnostics.

4. Procédé de diagnostic en temps réel et automatique dans des réseaux électriques, comprenant :
i. un moyen de génération de la topologie ;
ii. un moyen de vérification si l'équipement est connecté/énergisé ou non connecté ;
iii. un moyen de vérification si l'équipement a été connecté/énergisé ou non connecté ;
iv. un moyen d'interconnexion de réseaux et de modélisation de la connexion entre des équipements du réseau électrique ;
**caractérisé par** :
v. un moyen d'entretien d'une représentation de la topologie du réseau électrique, le système comprenant en outre :
vi. un moyen de création de paramètres topologiques pour insérer des règles génériques dans le type d'équipement et/ou le type/les types d'équipement et
vii. un moyen d'actualisation de l'état de la topologie, ledit moyen d'actualisation comprenant :
- la suppression d'un diagnostic/de diagnostics dont le symptôme/les symptômes ont expiré ;
- la récupération de diagnostics présentant des symptômes du réseau ; et
- l'adjonction de symptômes dans l'équipement associé ;
viii. un moyen de génération de diagnostics par des règles génériques en se basant sur une collecte d'informations ; et, en option,
ix. un moyen de génération des écrans de diagnostics, lesdites règles génériques étant appliquées sur les classes d'équipement, la translation si la ligne de transmission est connectée ou non à certains équipements énergisés, et comprenant une règle/des règles et/ou une macro/des macros et/ou un attribut/des attributs.
